# EUROPEAN PATENT APPLICATION

(11) **EP 4 637 301 A1**
(43) Date of publication of application: **22.10.2025**
(21) Application number: 25168981.6
(22) Date of filing: 07.04.2025
(51) Int. Cl.: H10F 39/00

(54) **PHOTOELECTRIC CONVERSION APPARATUS, PHOTOELECTRIC CONVERSION SYSTEM, AND MOBILE OBJECT**

(30) Priority: 15.04.2024 JP 2024065497
(71) Applicant: Canon Kabushiki Kaisha, Tokyo 146-8501 (JP)
(72) Inventor: YAMASAKI, Takahiro, Tokyo, 146-8501 (JP)
(74) Representative: Canon Europe Limited

(57) **Abstract**

A photoelectric conversion apparatus includes a first chip (100), a second chip (200), and a third chip (300) that are stacked. The first chip includes a first semiconductor layer (1100) having a photoelectric conversion unit and a first readout circuit, and a first wiring structure (1110). The second chip includes a second semiconductor layer (1200) having a memory and an output circuit, and a second wiring structure (1210). The third chip includes a third semiconductor layer (1300) having a second readout circuit, and a third wiring structure (1310). The first wiring structure includes a first line and a second line. The second wiring structure includes a third line and a fourth line. The third wiring structure includes a fifth line and a sixth line. At least two of the first to sixth lines are connected to each other between at least two of the first to third chips.

## Description

### BACKGROUND OF THE INVENTION

### Field of the Invention

The present invention relates to a photoelectric conversion apparatus, a photoelectric conversion system, and a mobile object.

### Description of the Related Art

One known photoelectric conversion apparatus includes an analog-to-digital (AD) conversion unit for each pixel column.

A photoelectric conversion apparatus of this type is an imaging apparatus described in International Publication No. 2021/215105. The imaging apparatus has a global shutter function for starting exposing all pixels at the same time.

International Publication No. 2021/215105 discloses an imaging apparatus including a plurality of substrates stacked on one another, but no consideration is given of the arrangement of a power supply and lines arranged on each substrate.

### SUMMARY OF THE INVENTION

The present invention in its first aspect provides a photoelectric conversion apparatus as specified in claims 1 to 10.

The present invention in its second aspect provides a photoelectric conversion system as specified in claim 11.

The present invention in its third aspect provides a mobile object as specified in claim 12.

Further features of the present invention will become apparent from the following description of embodiments with reference to the attached drawings.

### BRIEF DESCRIPTION OF THE DRAWINGS

Fig. 1 is a circuit diagram of an entire circuit according to a first embodiment.
Fig. 2 is a diagram of surfaces of stacked chips according to the first embodiment.
Fig. 3 is a circuit diagram of a readout circuit according to the first embodiment.
Fig. 4 is a circuit diagram of current sources according to the first embodiment.
Fig. 5 is a circuit diagram of an analog-to-digital converter (ADC) according to the first embodiment.
Fig. 6 is a layout diagram of pads according to the first embodiment.
Fig. 7 is a sectional view of the stacked chips according to the first embodiment.
Fig. 8 is a sectional view of the stacked chips according to the first embodiment.
Fig. 9 is a plan view of a pixel array according to the first embodiment.
Fig. 10 is a plan view of the chips according to the first embodiment.
Fig. 11 is a plan view of the chips according to the first embodiment.
Fig. 12 is a sectional view of the stacked chips according to the first embodiment.
Fig. 13 is a plan view of a pixel array according to the first embodiment.
Fig. 14 is a plan view of the chips according to the first embodiment.
Fig. 15 is a circuit diagram of the readout circuit according to the first embodiment.
Fig. 16 is a circuit diagram of a readout circuit according to a second embodiment.
Fig. 17 is a sectional view of stacked chips according to the second embodiment.
Fig. 18 is a plan view of a pixel array according to the second embodiment.
Fig. 19 is a sectional view of the stacked chips according to the second embodiment.
Fig. 20 is a plan view of the pixel array according to the second embodiment.
Fig. 21 is a circuit diagram of a readout circuit according to a third embodiment.
Fig. 22 is a circuit diagram of current sources according to the third embodiment.
Fig. 23 is a layout diagram of pads according to the third embodiment.
Fig. 24 is a sectional view of stacked chips according to the third embodiment.
Fig. 25 is a sectional view of the stacked chips according to the third embodiment.
Fig. 26 is a sectional view of the stacked chips according to the third embodiment.
Fig. 27 is a circuit diagram of a readout circuit according to a fourth embodiment.
Fig. 28 is a circuit diagram of current sources according to the fourth embodiment.
Fig. 29 is a layout diagram of pads according to the fourth embodiment.
Fig. 30 is a sectional view of stacked chips according to the fourth embodiment.
Fig. 31 is a sectional view of the stacked chips according to the fourth embodiment.
Fig. 32 is a plan view of a pixel array according to the fourth embodiment.
Fig. 33 is a circuit diagram of a readout circuit according to a fifth embodiment.
Fig. 34 is a circuit diagram of buffers according to the fifth embodiment.
Fig. 35 is a layout diagram of pads according to the fifth embodiment.
Fig. 36 is a sectional view of stacked chips according to the fifth embodiment.
Fig. 37 is a sectional view of the stacked chips according to the fifth embodiment.
Fig. 38 is a layout diagram of pads according to a sixth embodiment.
Fig. 39 is a sectional view of stacked chips according to the sixth embodiment.
Fig. 40 is a sectional view of the stacked chips according to the sixth embodiment.
Fig. 41 is a sectional view of the stacked chips according to the sixth embodiment.
Fig. 42 is a sectional view of the stacked chips according to the sixth embodiment.
Fig. 43A, Fig. 43B, and Fig. 43C are functional block diagrams of a photoelectric conversion system according to a seventh embodiment.

### DESCRIPTION OF THE EMBODIMENTS

The size and positional relationships of components illustrated in the drawings may be exaggerated for clarity. Each of the embodiments of the present invention described below can be implemented solely or as a combination of a plurality of the embodiments of features thereof where necessary or where the combination of elements or features from individual embodiments in a single embodiment is beneficial. In the following description, the same components are denoted by the same reference numerals, and a description thereof may be omitted.

Embodiments of the present invention will be described in detail hereinafter with reference to the drawings. The following description uses terms indicating specific directions and positions (e.g., "up", "down", "right", "left", and other terms including these terms) as necessary. These terms are used to facilitate understanding of the embodiments with reference to the drawings, and the meanings of these terms do not limit the technical scope of the present invention.

As used herein, the term "plan view" refers to a view from a direction perpendicular to a light incident surface of a semiconductor layer. The term "sectional view" refers to a view of a cross section perpendicular to the light incident surface of the semiconductor layer. In a case where the light incident surface of the semiconductor layer appears coarse when viewed microscopically, the term "plan view" is defined based on the light incident surface of the semiconductor layer as viewed macroscopically.

When the term "impurity concentration" is simply used herein, it means a net impurity concentration obtained by subtracting an amount compensated for by impurities of the opposite conductivity type. In short, the term "impurity concentration" refers to a net doping concentration. A region where the P-type dopant impurity concentration is higher than the N-type dopant impurity concentration is a P-type semiconductor region. Conversely, a region where the N-type dopant impurity concentration is higher than the P-type dopant impurity concentration is an N-type semiconductor region.

Further, the following embodiments describe connections between elements of a circuit in some cases. In such cases, even when elements of interest are connected to each other with another element interposed therebetween, the elements of interest are considered to be connected to each other unless otherwise specified. For example, capacitive element C with multiple nodes has one node connected to element A and another node connected to element B. Even in this case, the element A and the element B are considered to be connected to each other unless otherwise specified.

### First Embodiment

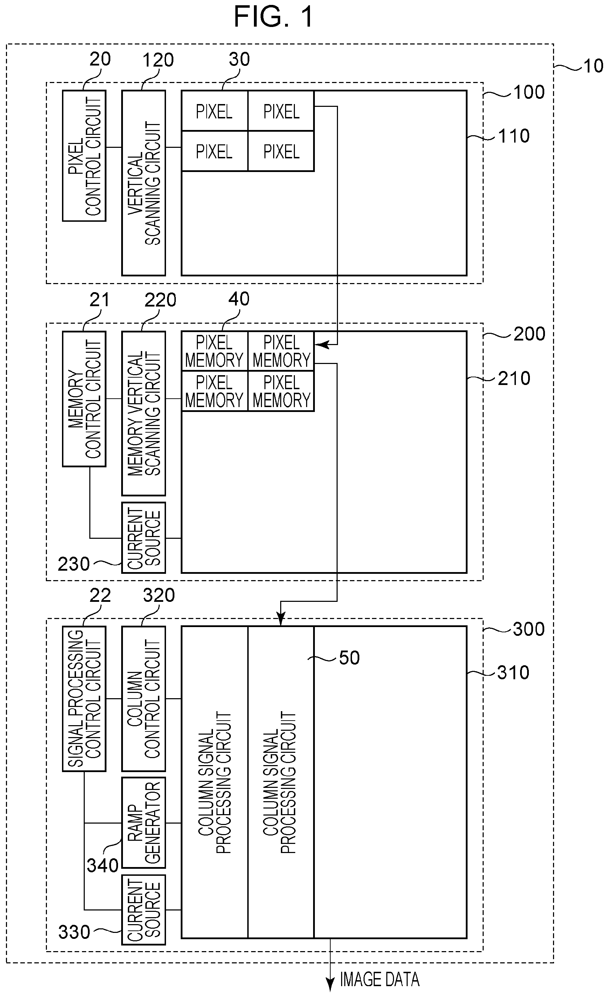

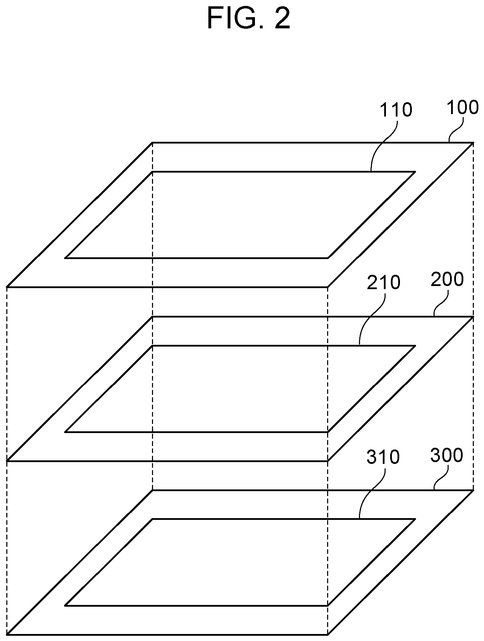

A first embodiment will be described with reference to Figs. 1 to 15. Fig. 1 is a schematic diagram illustrating a photoelectric conversion apparatus 10 according to an embodiment of the present invention. The photoelectric conversion apparatus 10 has a configuration in which a pixel chip 100 (first chip), a memory chip 200 (second chip), and a signal processing chip 300 (third chip) are stacked in a manner illustrated in Fig. 2. The chips 100, 200, and 300 have lines that are bonded to one another, thereby allowing signals to be exchanged among the chips 100, 200, and 300.

The pixel chip 100 illustrated in Fig. 1 includes a pixel region 110, a vertical scanning circuit 120, and a pixel control circuit 20. The pixel region 110 is a region in which pixels 30, each being a unit pixel, are arranged in an array of rows and columns. Each of the pixels 30 includes a photoelectric conversion element such as a photodiode and outputs a signal voltage corresponding to an amount of incident light. The pixel region 110 may have an optical black pixel in which a photoelectric conversion unit is shielded from light, a dummy pixel that does not output a signal, or the like, in addition to effective pixels that output signal voltages (pixel signals) corresponding to amounts of incident light. The numbers of rows and columns of a pixel array arranged in the pixel region 110 are not limited. The pixel control circuit 20 is a logic circuit that performs timing generation to operate the pixels 30, and outputs drive pulses for the pixels 30 to the vertical scanning circuit 120. The vertical scanning circuit 120 includes a driver for driving the pixels 30 row by row.

The memory chip 200 includes a memory region 210, a memory vertical scanning circuit 220, a current source 230, and a memory control circuit 21. The memory region 210 is a region in which pixel memories 40 are arranged in an array of rows and columns. The pixel memories 40 have a function of holding the signal voltages output from the pixels 30. The number of pixels 30 need not be equal to the number of pixel memories 40. For example, no pixel memory 40 may be arranged for a dummy pixel from which no signal is output. Alternatively, a dummy pixel memory that does not output a signal may be arranged so as to correspond to the dummy pixel. The current source 230 supplies a reference current to the pixel memories 40. The memory control circuit 21 includes a logic circuit that performs timing generation to operate the pixel memories 40 and controls a circuit such as the current source 230 arranged near the pixel memories 40. A drive pulse output from the memory control circuit 21 is input to the memory vertical scanning circuit 220. The memory vertical scanning circuit 220 includes a driver for driving the pixel memories 40 row by row.

The signal processing chip 300 includes a signal processing unit 310, a column control circuit 320, a ramp generator 340, a current source 330, and a signal processing control circuit 22. The signal processing unit 310 includes column signal processing circuits 50 arranged in an array of columns. The column signal processing circuits 50 have a function of performing analog-to-digital (AD) conversion on the signal voltages output from the pixel memories 40 based on a reference voltage generated by the ramp generator 340, and output the converted signals to the outside of the signal processing chip 300 as image data.

While the present embodiment describes ramp-type AD conversion as an example, the AD conversion method is not limited to the ramp type. The column signal processing circuits 50 may have a function of performing digital processing such as noise processing on the image data. The current source 330 supplies a reference current to the column signal processing circuits 50. The signal processing control circuit 22 includes a logic circuit that performs timing generation to operate the column signal processing circuits 50 and sets functions of the ramp generator 340 and the current source 330. A drive pulse output from the signal processing control circuit 22 is input to the column control circuit 320. The column control circuit 320 includes a driving driver that outputs drive pulses to the column signal processing circuits 50.

The pixel chip 100, the memory chip 200, and the signal processing chip 300 are stacked in the manner illustrated in Fig. 2 to construct the photoelectric conversion apparatus 10.

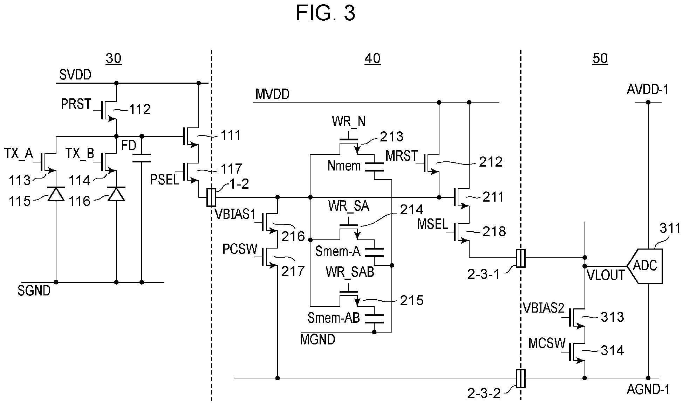

The photoelectric conversion apparatus 10 according to the present embodiment is a photoelectric conversion apparatus that performs a so-called voltage-domain global shutter operation. An example configuration of a signal readout circuit for the pixels 30 in the photoelectric conversion apparatus 10 according to the present embodiment will be described with reference to Fig. 3.

Each of the pixels 30 includes a photodiode (PD) 115, a PD 116, a pixel transfer transistor 113, a pixel transfer transistor 114, and a pixel reset transistor 112. The pixel 30 further includes a pixel amplification transistor 111, a pixel selection transistor 117, and a floating diffusion capacitor (FD capacitor).

The photoelectric conversion apparatus 10 according to the present embodiment is a photoelectric conversion apparatus supporting so-called phase detection autofocus (PDAF) in which the PDs 115 and 116 form each pixel and signals of the PDs 115 and 116 are used to detect a phase difference.

The photoelectric conversion apparatus 10 is an imaging apparatus (in this example, a complementary metal oxide semiconductor (CMOS) sensor) that uses a signal of at least one of the PDs 115 and 116 to generate an image. An anode terminal of the PD 115 is connected to a reference power source SGND, and a cathode terminal of the PD 115 is connected to a source of the pixel transfer transistor 113. An anode terminal of the PD 116 is connected to the reference power source SGND, and a cathode terminal of the PD 116 is connected to a source of the pixel transfer transistor 114. A drain of the pixel transfer transistor 113 and a drain of the pixel transfer transistor 114 are connected to a gate of the pixel amplification transistor 111 and a source of the pixel reset transistor 112. The FD capacitor is connected to a gate of the pixel amplification transistor 111 with the reference power source SGND as the reference, and can hold signal charges generated by the PDs 115 and 116. A drain of the pixel reset transistor 112 and a drain of the pixel amplification transistor 111 are connected to a reference power source SVDD. A source of the pixel amplification transistor 111 is connected to a drain of the pixel selection transistor 117.

When light is incident on each of the PDs 115 and 116, photoelectric conversion occurs, and charges corresponding to the incident light are generated. When a control signal TX_A output from the vertical scanning circuit 120 is input to the gate of the pixel transfer transistor 113, the pixel transfer transistor 113 is turned on, and the charges generated by the PD 115 are transferred to the FD capacitor. When a control signal TX_B output from the vertical scanning circuit 120 is input to the gate of the pixel transfer transistor 114, the pixel transfer transistor 114 is turned on, and the charges generated by the PD 116 are transferred to the FD capacitor. When a control signal PRST is input to the gate of the pixel reset transistor 112, the FD capacitor is connected to the reference power source SVDD, and a reset operation is performed to extract the charges held in the FD capacitor.

The charges held in the FD capacitor are converted into a voltage by the pixel amplification transistor 111, and the voltage is output as a signal voltage from the pixel 30 in accordance with a control signal PSEL input to the gate of the pixel selection transistor 117. The output of the pixel 30 is input to a corresponding pixel memory 40 of the pixel memories 40 via a bonding portion 1-2 that bonds the pixel chip 100 and the memory chip 200 to each other.

Next, an example configuration of the pixel memory 40 will be described. The pixel memory 40 includes a signal holding memory Nmem, a signal holding memory Smem-A, and a signal holding memory Smem-AB. The signal holding memory Nmem includes a memory write transistor 213. The signal holding memory Smem-A includes a memory write transistor 214. The signal holding memory Smem-AB includes a memory write transistor 215. The pixel memory 40 further includes a memory reset transistor 212, a memory amplification transistor 211, a current source transistor 216, a switch transistor 217, and a memory selection transistor 218.

A source of the pixel selection transistor 117 of the pixel 30 is connected to a drain of the current source transistor 216 of the pixel memory 40 via the bonding portion 1-2. A source of the current source transistor 216 is connected to a drain of the switch transistor 217. A source of the switch transistor 217 is connected to a power supply line for supplying a reference power source AGND-1 via a bonding portion 2-3-2. At this time, a gate of the current source transistor 216 is supplied with a gate voltage VBIAS1 from the current source 230 to perform control such that a current based on the gate voltage VBIAS1 flows through the current source transistor 216. The configuration of the current source 230 will be described below.

The signal holding memory Nmem has one terminal connected to a power supply line for supplying a reference power source MGND, and another terminal connected to a source of the memory write transistor 213. A drain of the memory write transistor 213 is connected to a gate of the memory amplification transistor 211. The signal holding memory Smem-A has one terminal connected to the power supply line for supplying the reference power source MGND, and another terminal connected to a source of the memory write transistor 214. A drain of the memory write transistor 214 is connected to the gate of the memory amplification transistor 211. The signal holding memory Smem-AB has one terminal connected to the power supply line for supplying the reference power source MGND, and another terminal connected to a source of the memory write transistor 215. A drain of the memory write transistor 215 is connected to the gate of the memory amplification transistor 211.

In this case, it is sufficient that each of the signal holding memories Nmem, Smem-A, and Smem-AB be an element having a function of holding a signal. Examples of such an element include a dynamic random access memory (DRAM) and a metal-insulator-metal (MIM) capacitor.

The memory vertical scanning circuit 220 outputs a control signal WR_N, a control signal WR_SA, and a control signal WR_SAB. The control signal WR_N is input to a gate of the memory write transistor 213. The control signal WR_SA is input to a gate of the memory write transistor 214. The control signal WR_SAB is input to a gate of the memory write transistor 215. When the memory write transistor 213 is turned on by the control signal WR_N output from the memory vertical scanning circuit 220, a signal voltage output from the pixel amplification transistor 111 is written to the signal holding memory Nmem. Likewise, a signal voltage can be written to the signal holding memory Smem-A in response to the control signal WR_SA, and a signal voltage can be written to the signal holding memory Smem-AB in response to the control signal WR_SAB. A signal voltage after the FD capacitor is reset by the pixel reset transistor 112 is held in the signal holding memory Nmem, and a signal voltage based on the signal charges generated by the PD 115 is held in the signal holding memory Smem-A. Further, a signal voltage based on the sum of the signal charges generated by the PDs 115 and 116 can be held in the signal holding memory Smem-AB.

When a control signal MRST output from the memory vertical scanning circuit 220 is input to a gate of the memory reset transistor 212, the memory reset transistor 212 writes a voltage supplied from a reference power source MVDD to the signal holding memories Nmem, Smem-A, and Smem-AB. In other words, the signal voltage held in each signal holding memory can be reset.

A source of the memory reset transistor 212 is connected to the gate of the memory amplification transistor 211, and a drain of the memory reset transistor 212 is connected to a power supply line for supplying the reference power source MVDD. A source of the memory amplification transistor 211 is connected to a drain of the memory selection transistor 218.

The pixel selection transistor 117 is turned on when the control signal PSEL output from the vertical scanning circuit 120 is input to the gate of the pixel selection transistor 117. At the same time, the switch transistor 217 is turned on when a control signal PCSW output from the memory vertical scanning circuit 220 is input to a gate of the switch transistor 217. Accordingly, the current based on the gate voltage VBIAS1 of the current source transistor 216 flows to the pixel amplification transistor 111, and the pixel amplification transistor 111 performs a source follower operation. As a result, a signal voltage based on the charges held in the FD capacitor is output to the gate of the memory amplification transistor 211 connected to the bonding portion 1-2.

A signal amplified by the memory amplification transistor 211 is output from the pixel memory 40 in accordance with a control signal MSEL input to a gate of the memory selection transistor 218. The output of the pixel memory 40 is input to a corresponding column signal processing circuit 50 of the column signal processing circuits 50 via a bonding portion 2-3-1 that bonds the memory chip 200 and the signal processing chip 300 to each other.

An example configuration of the column signal processing circuit 50 will be described. The column signal processing circuit 50 includes an ADC 311, a current source transistor 313, and a switch transistor 314.

A source of the current source transistor 313 is connected to a drain of the switch transistor 314, and a source of the switch transistor 314 is connected to the power supply line for supplying the reference power source AGND-1. At this time, a gate of the current source transistor 313 is supplied with a gate voltage VBIAS2 from the current source 330, and a current based on the gate voltage VBIAS2 flows through the current source transistor 313.

The memory selection transistor 218 is turned on when the control signal MSEL output from the memory vertical scanning circuit 220 is input to the gate of the memory selection transistor 218, and the switch transistor 314 is turned on by a control signal MCSW output from the column control circuit 320. A current flows through the memory amplification transistor 211, and a signal voltage based on the gate voltage of the memory amplification transistor 211 is output to a signal line VLOUT via the bonding portion 2-3-1.

At this time, the signal holding memories Nmem are selected by the control signal WR_N, and the respective signal voltages written in the signal holding memories Nmem can be sequentially read out. Likewise, the signal holding memories Smem-A are selected by the control signal WR_SA, and the respective signal voltages written in the signal holding memories Smem-A can be sequentially read out. The signal holding memories Smem-AB are selected by the control signal WR_SAB, and the respective signal voltages written in the signal holding memories Smem-AB can be sequentially read out.

In this configuration, the bonding portion 1-2 represents a bonding portion at which the pixel chip 100 and the memory chip 200 are bonded together. The bonding portions 2-3-1 and 2-3-2 represent bonding portions at which the memory chip 200 and the signal processing chip 300 are bonded together. The chips 100, 200, and 300 are electrically connected to one another by bonding portions (e.g., the bonding portions 1-2, 2-3-1, and 2-3-2). The bonding portions are constructed using bonding technology such as Cu-to-Cu bonding (CCB) or through-silicon via (TSV).

In the present embodiment, the pixel chip 100, the memory chip 200, and the signal processing chip 300 are bonded in accordance with paths for reading out signals photoelectrically converted by the PDs 115 and 116 from the pixels 30.

Further, a reference power source is supplied from the signal processing chip 300 to the memory chip 200 via the bonding portion 2-3-2.

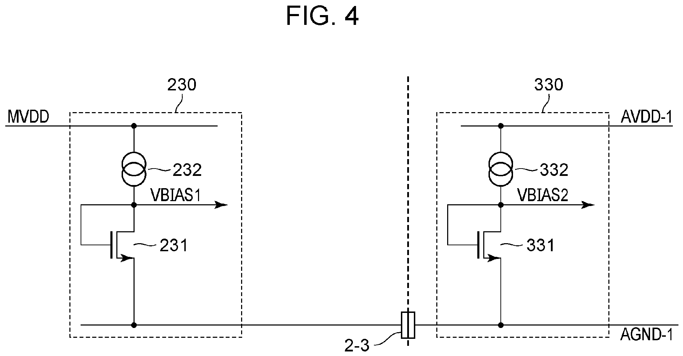

Fig. 4 illustrates an example configuration of the current sources 230 and 330 in Fig. 1.

The current source 230 includes a reference current source 232 and a bias generation transistor 231 to form a current mirror. The reference current source 232 configured to generate a reference current is connected between the power supply line for supplying the reference power source MVDD and a drain of the bias generation transistor 231. A source of the bias generation transistor 231 is connected to the power supply line for supplying the reference power source AGND-1. A gate of the bias generation transistor 231 is connected to the drain of the bias generation transistor 231 to generate the gate voltage VBIAS1, which is supplied to each of the pixel memories 40.

The current source 330 includes a reference current source 332 and a bias generation transistor 331 to form a current mirror. The reference current source 332 configured to generate a reference current is connected between a power supply line for supplying a reference power source AVDD-1 and a drain of the bias generation transistor 331. A source of the bias generation transistor 331 is connected to the power supply line for supplying the reference power source AGND-1.

A gate of the bias generation transistor 331 is connected to the drain of the bias generation transistor 331 to generate the gate voltage VBIAS2, which is supplied to each of the column signal processing circuits 50.

A drain of the current source transistor 313 is connected to the input of the ADC 311 through the signal line VLOUT. The ADC 311 is connected to the power supply line for supplying the reference power source AVDD-1 and the power supply line for supplying the reference power source AGND-1.

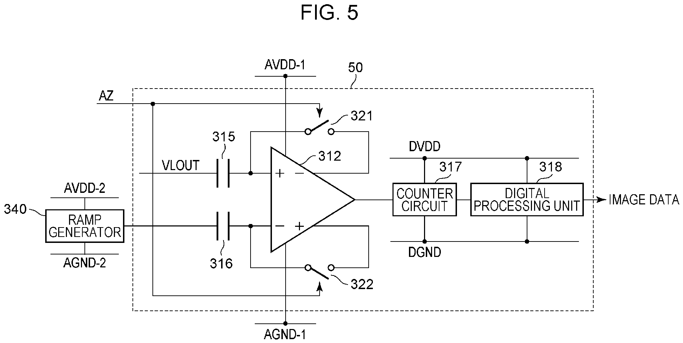

Fig. 5 illustrates an example configuration of the ADC 311 in Fig. 3. The ADC 311 includes a comparator 312, a clamp capacitor 315, a clamp capacitor 316, a counter circuit 317, and a digital processing unit 318.

The comparator 312 has a non-inverting input terminal (+), an inverting input terminal (-), an inverting output terminal (-), and a non-inverting output terminal (+). The non-inverting input terminal (+) is connected via the clamp capacitor 315 to the signal line VLOUT through which a signal is output from the pixel memory 40.

An output terminal of the ramp generator 340 is connected to the inverting input terminal (-) via the clamp capacitor 316. The ramp generator 340 is connected to a power supply line for supplying a reference power source AVDD-2 and a power supply line for supplying a reference power source AGND-2. The non-inverting input terminal (+) and the inverting output terminal (-) are connected through a switch 321, and the inverting input terminal (-) and the non-inverting output terminal (+) are connected through a switch 322. The switches 321 and 322 are reset switches for initializing the comparator 312, and are turned on by a control signal AZ output from the column control circuit 320.

The comparator 312 compares a signal voltage VOUT output from the pixel memory 40 to the signal line VLOUT with a reference signal RAMP generated by the ramp generator 340, and outputs the result to the counter circuit 317. For example, when the signal voltage VOUT is larger than the reference signal RAMP, the comparator 312 outputs a high level. When the signal voltage VOUT is smaller than the reference signal RAMP, the comparator 312 outputs a low level. Here, the magnitude relationship of the input signal with respect to the outputs, namely, the high level and the low level, may be reversed. The counter circuit 317 counts the time taken for the output of the comparator 312 to be inverted from the high level to the low level, and outputs the value as a digital signal to the digital processing unit 318. The digital processing unit 318 has a function of performing digital processing. Examples of the digital processing include amplification processing and correction processing based on correlated double sampling. The counter circuit 317 and the digital processing unit 318 are supplied with a reference power source DVDD and a reference power source DGND.

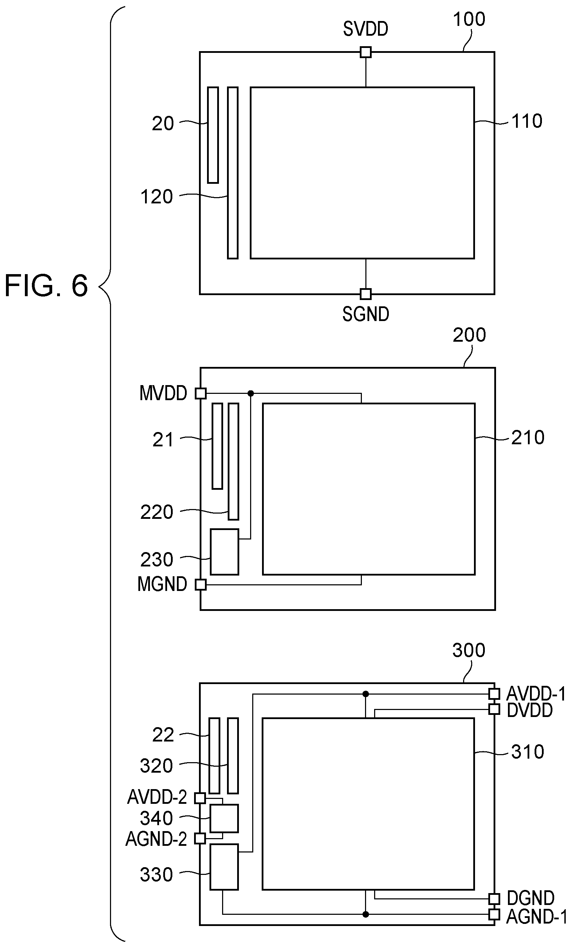

A method for supplying power to each chip of the photoelectric conversion apparatus 10 according to the present embodiment and a wiring structure of each semiconductor substrate will be described in detail hereinafter. Fig. 6 is a pad layout diagram illustrating an example layout of pads for supplying power.

The pixel chip 100 is provided with a pad for supplying the reference power source SVDD and a pad for supplying the reference power source SGND, and the reference power source SVDD and the reference power source SGND are supplied to the pixels 30 in the pixel region 110 through wiring in the pixel chip 100.

The memory chip 200 is provided with a pad for supplying the reference power source MVDD and a pad for supplying the reference power source MGND, and the reference power source MVDD and the reference power source MGND are supplied to the pixel memories 40 in the memory region 210 through wiring in the memory chip 200. The reference power source MVDD is supplied to the current source 230.

The signal processing chip 300 is provided with a pad for supplying the reference power source AVDD-1, a pad for supplying the reference power source AVDD-2, a pad for supplying the reference power source AGND-1, a pad for supplying the reference power source AGND-2, a pad for supplying the reference power source DVDD, and a pad for supplying the reference power source DGND. The reference power source AVDD-1, the reference power source AGND-1, the reference power source DVDD, and the reference power source DGND are supplied to the signal processing unit 310 and the column signal processing circuits 50. The reference power source AVDD-2 and the reference power source AGND-2 are supplied to the ramp generator 340. The reference power source AVDD-1 and the reference power source AGND-1 are supplied to the current source 330. While the connection relationship between each reference power source and the inside of the circuit is as illustrated in Figs. 3, 4, and 5, pads are also arranged for the other circuits in the pixel chip 100, the memory chip 200, and the signal processing chip 300 to supply reference power sources through power supply lines.

In this case, the voltage magnitude relationships of the reference power sources described above are SVDD > SGND, MVDD > AGND-1, (AVDD-1, AVDD-2) > (AGND-1, AGND-2), and DVDD > DGND. When the reference power source DVDD is first power, the reference power source DGND may be considered to be second power different from the first power. Typically, the voltage of a logic circuit unit is lower than that of a circuit that outputs a signal. Accordingly, the reference power source DVDD is lower in voltage than the reference power source SVDD, the reference power source MVDD, the reference power source AVDD-1, and the reference power source AVDD-2. The voltage magnitude relationships of the reference power source SVDD, the reference power source MVDD, the reference power source AVDD-1, and the reference power source AVDD-2 are not limited.

For example, due to the source follower operation of the pixel amplification transistor 111 in Fig. 3, the signal output with respect to the signal voltage of the FD capacitor decreases by an amount corresponding to a threshold voltage for the pixel amplification transistor 111. Therefore, the upper limit of the input range of the memory amplification transistor 211 may be lower than that of the pixel amplification transistor 111. That is, a relationship of SVDD > MVDD may be satisfied. However, if SVDD > MVDD is satisfied, the lower-limit voltage of the input range of the memory amplification transistor 211 may be constrained. To address the constraint, a relationship of SGND > AGND-1 may be further be satisfied.

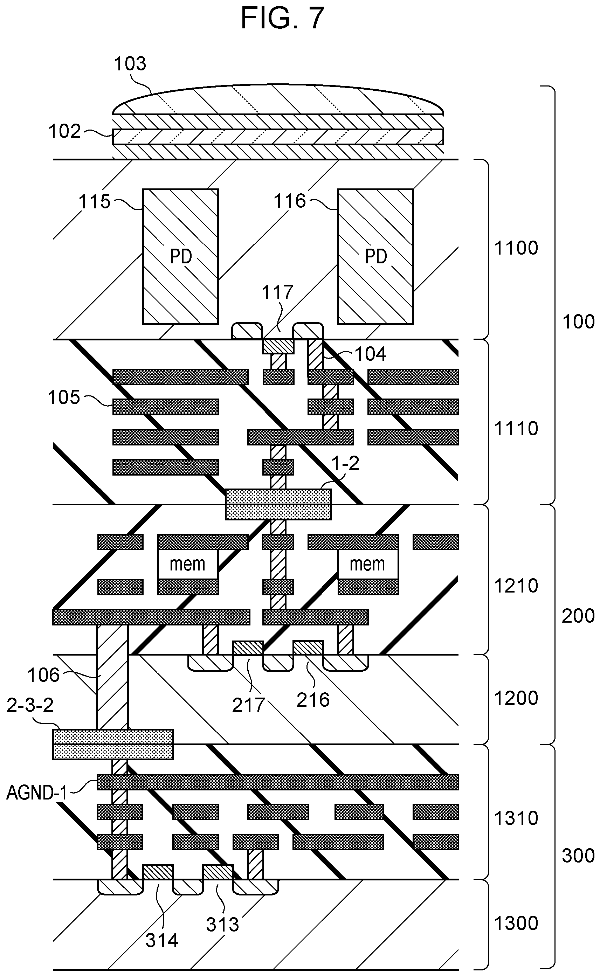

In this case, the reference power source AGND-1 is supplied to both the memory chip 200 and the signal processing chip 300 via the bonding portion 2-3-2 in Fig. 3 and a bonding portion 2-3 in Fig. 4. The cross-sectional structure of the pixel chip 100, the memory chip 200, and the signal processing chip 300, which are bonded to each other, will be described with reference to Fig. 7.

The pixel chip 100 includes a pixel Si substrate 1100 and a pixel chip wiring structure 1110. The pixel Si substrate 1100 is a silicon semiconductor substrate, and is a first semiconductor layer including a photoelectric conversion unit and a first readout circuit for reading out a signal based on photoelectric conversion of the photoelectric conversion unit.

Fig. 7 illustrates the PD 115, the PD 116, and the pixel selection transistor 117 as an example of elements provided in the pixel Si substrate 1100. A microlens 103 and a color filter 102 are formed on the light incident surface side of the pixel Si substrate 1100. The color filter 102 has a function of limiting the wavelength band of incident light. For example, the color filter 102 allows light in a wavelength band corresponding to each of red, green, and blue colors of visible light to pass therethrough. The microlens 103 has a function of condensing incident light on the PDs 115 and 116.

In the pixel chip wiring structure 1110, metal lines 105 each for connecting circuits are arranged in multiple layers. The pixel chip wiring structure 1110 includes contact vias 104 through which the metal lines 105 in the respective layers are connected to each other and the metal lines 105 are connected to the pixel Si substrate 1100 and transistors formed in the pixel Si substrate 1100. The pixel chip wiring structure 1110 is a first wiring structure electrically connected to the photoelectric conversion unit and the first readout circuit. The first wiring structure includes a first line for supplying power to the photoelectric conversion unit and a second line for supplying power to the first readout circuit.

The memory chip 200 includes a memory Si substrate 1200 and a memory chip wiring structure 1210. The memory Si substrate 1200 is a silicon semiconductor substrate and is a second semiconductor layer including a memory and an output circuit that outputs a voltage held in the memory. Fig. 7 illustrates the current source transistor 216 and the switch transistor 217 as an example of elements provided in the memory Si substrate 1200.

Like the pixel chip wiring structure 1110, the memory chip wiring structure 1210 is also a wiring structure including the metal lines 105 and the contact vias 104. The signal holding memory Nmem, the signal holding memory Smem-A, and the signal holding memory Smem-AB in Fig. 3 are formed in the memory chip wiring structure 1210. The memory chip wiring structure 1210 is a second wiring structure in which each signal holding memory is electrically connected to the output circuit. The second wiring structure includes a third line for supplying power to the signal holding memory and a fourth line for supplying power to the output circuit. As long as the signal holding memory has a function of holding a signal voltage, a capacitor may be formed in the memory Si substrate 1200 to hold a signal.

The signal processing chip 300 includes a signal processing Si substrate 1300 and a signal processing chip wiring structure 1310. The signal processing Si substrate 1300 is a silicon semiconductor substrate and is a third semiconductor layer including a second readout circuit that reads out a signal corresponding to the voltage held in the memory. Fig. 7 illustrates the current source transistor 313 and the switch transistor 314 as an example of elements provided in the signal processing Si substrate 1300.

Like the pixel chip wiring structure 1110, the signal processing chip wiring structure 1310 is a third wiring structure including the metal lines 105 and the contact vias 104 and electrically connected to the second readout circuit. The third wiring structure includes a fifth line for supplying power to the second readout circuit and a sixth line for supplying power to the second readout circuit.

As illustrated in Fig. 7, the pixel chip wiring structure 1110 of the pixel chip 100 and the memory chip wiring structure 1210 of the memory chip 200 are bonded together so as to face each other, and are electrically connected to each other via the bonding portion 1-2. In Fig. 7, the bonding portion 1-2 is a so-called CCB portion constructed by bonding together a Cu pad formed on a bottom surface of the pixel chip wiring structure 1110 and a Cu pad formed on a top surface of the memory chip wiring structure 1210 and connecting the Cu pads to each other.

The memory chip wiring structure 1210 of the memory chip 200 and the signal processing chip wiring structure 1310 of the signal processing chip 300 are connected to each other through the memory Si substrate 1200. The memory Si substrate 1200 has formed therein a TSV 106 to be connected to a Cu pad prepared on a bottom surface of the memory Si substrate 1200. This Cu pad is bonded to a Cu pad formed on a top surface of the signal processing chip wiring structure 1310 to form the bonding portion 2-3-2 based on CCB.

The pixel selection transistor 117 is connected to the switch transistor 217 via the bonding portion 1-2. The reference power source AGND-1 supplied to the column signal processing circuits 50 is connected to the switch transistor 217 arranged in the memory chip 200 via the bonding portion 2-3-2. In other words, the power supply line arranged in the memory chip 200 to supply the reference power source AGND-1 and the power supply line arranged in the signal processing chip 300 to supply the reference power source AGND-1 form a common power supply line with the bonding portion 2-3-2 interposed therebetween. The fourth line for supplying power to the output circuit and the sixth line for supplying power to the second readout circuit can be considered to be connected to each other between the second chip and the third chip.

In the configuration illustrated in Fig. 3, the reference power source AGND-1 is supplied to the memory chip 200 and the signal processing chip 300 through a common power supply line. This configuration can reduce the wiring resistance to 1/2 as compared with a case where separate lines are provided for the respective chips. The reduction in the resistance of the power supply line is important for the performance of the photoelectric conversion apparatus. This will be described hereinafter.

First, the current source transistor 216 and the current source transistor 313 cause a current to flow through the power supply line for supplying the reference power source AGND-1. For example, to read out the signal voltage held in the FD capacitor, the current flowing through the power supply line for supplying the reference power source AGND-1 increases with the number of pixel memories 40 to be operated simultaneously. Also to read out the signal voltages from the signal holding memories Nmem, Smem-A, and Smem-AB to the signal line VLOUT, the current flowing through the power supply line for supplying the reference power source AGND-1 increases with the number of column signal processing circuits 50 to be operated simultaneously. The flow of a current through a power supply line for supplying a reference power source causes fluctuations in voltage due to the wiring resistance of each reference power source, which constrains the dynamic range of each circuit. The constraint of the dynamic range of the pixel amplification transistor 111 or the memory amplification transistor 211 that performs the signal readout operation leads to a constraint of the dynamic range of the signal voltage with respect to the amount of incident light. As a result, the performance of the photoelectric conversion apparatus 10 is degraded. Power supply fluctuations can be reduced by decreasing the numbers of pixel memories 40 and column signal processing circuits 50 to be operated simultaneously. However, the decrease in the numbers of pixel memories 40 and column signal processing circuits 50 to be operated simultaneously may decrease the frame rate of the photoelectric conversion apparatus 10.

In addition, due to the increase in the pixel count of the photoelectric conversion apparatus 10, the pixels 30 are miniaturized, and wiring pitches are reduced. As a result, the parasitic capacitance between a readout path for signal voltages and a line for a reference power source is increased. The fluctuations in voltage on the power supply line for supplying the reference power source are propagated to the signal wiring, which may deteriorate the image quality.

Reducing the wiring resistance of the power supply line can reduce power supply fluctuations regardless of the number of pixels 30 to be simultaneously subjected to a signal readout operation, and thus an improvement in frame rate can also be expected.

In the present embodiment, as an example, the fourth line and the sixth line are connected to each other between the second chip and the third chip. However, the combination of lines to be connected and the combination of reference power sources (voltages) to be shared are not limited to those in the example. As long as the voltage magnitude relationships described above are satisfied, at least two of the first to sixth lines are connected to each other between at least two of the first, second, and third chips.

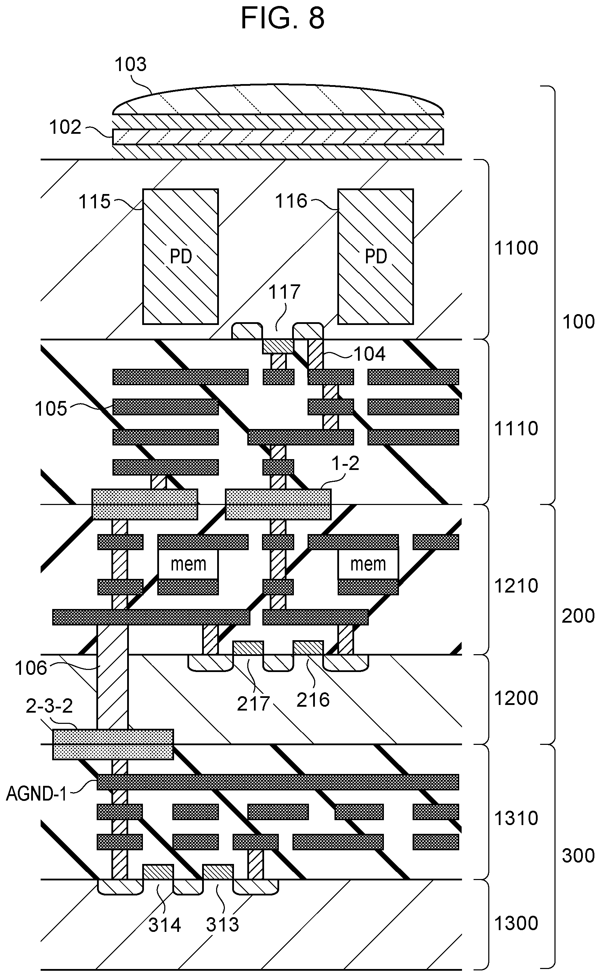

As a modification of the photoelectric conversion apparatus 10 according to the present embodiment, a configuration for further reducing the wiring resistance is illustrated in Fig. 8. In the configuration illustrated in Fig. 8, in addition to the bonding portion 1-2 between the pixel chip 100 and the memory chip 200 and the configuration illustrated in Fig. 7, the pixel chip wiring structure 1110 is also provided with a power supply line for supplying the reference power source AGND-1. In the configuration illustrated in Fig. 8, the reference power source AGND-1 is supplied to the three chips, namely, the pixel chip 100, the memory chip 200, and the signal processing chip 300, through a common line, and the wiring resistance can further be reduced.

In general, a power supply line for supplying a reference power source is used as a shield line for preventing signal line crosstalk. In stacked chips, a signal path is formed in the depth direction of the chips. Thus, a shield line may be provided across the pixel chip 100, the memory chip 200, and the signal processing chip 300 in order to prevent signal line crosstalk. In the configuration illustrated in Fig. 8, the common line formed across the three chips can also expect to achieve an effect of preventing crosstalk of output signals between adjacent pixels 30.

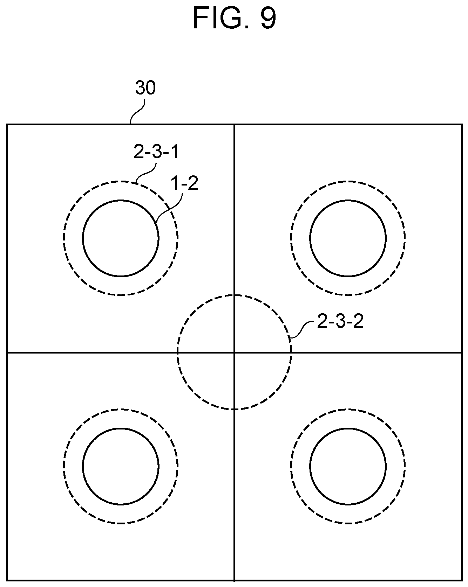

Fig. 9 is a plan view of the bonding portions arranged in Fig. 7 as viewed from above the pixel chip 100. In Fig. 9, four pixels 30 arranged in two rows and two columns are illustrated, and each of the pixels 30 is provided with the bonding portions 1-2 and 2-3-1 serving as paths for outputting signals. The bonding portions 1-2 and 2-3-1 are desirably arranged at the same pitch in consideration of signal crosstalk between adjacent pixels 30.

In general, a TSV tends to have a large diameter compared to CCB. Thus, it is more difficult to reduce the pitch between bonding portions when TSV is used, compared to when CCB is used. Accordingly, as illustrated in Fig. 9, the bonding portion 2-3-2 (see Fig. 3) may be arranged at the center of the pixels 30 arranged in two rows and two columns. If the TSV 106 can be constructed to have a sufficiently small diameter with respect to the pixels 30, the bonding portion 2-3-2 may be arranged at the center of each of the pixels 30.

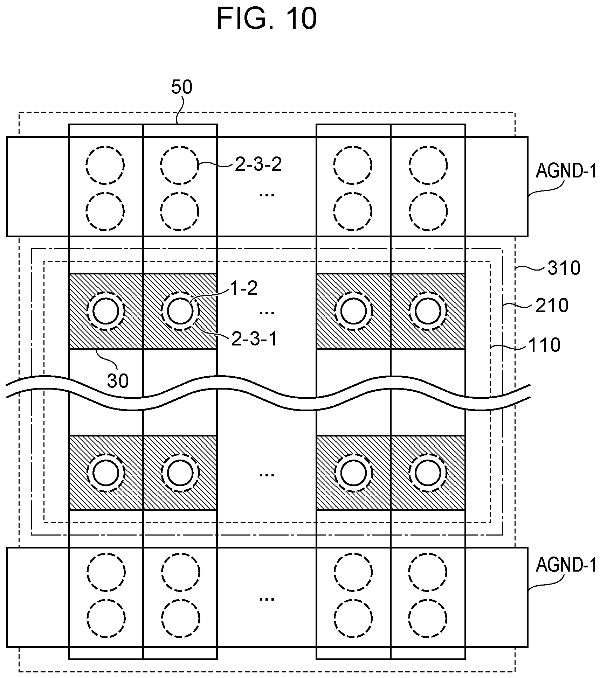

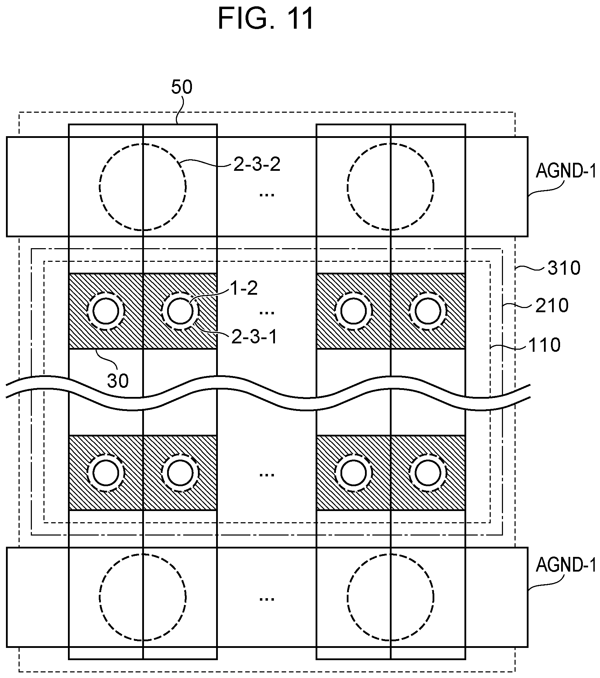

Figs. 10 and 11 illustrate plan views of the arrangement where TSVs 106 are connected outside the pixel region 110.

As illustrated in Fig. 10, in a plan view of the photoelectric conversion apparatus 10, the pixel region 110, the memory region 210, and the signal processing unit 310 are arranged so as to overlap each other, and each of the pixels 30 is provided with the bonding portions 1-2 and 2-3-1 that overlap each other. In contrast, the bonding portions 1-2 and 2-3-1 are not necessary in a region outside the pixel region 110 and the memory region 210. Thus, a large number of bonding portions 2-3-2 can be provided with respect to the memory region 210.

As illustrated in Fig. 11, the bonding portions 2-3-2 may have a larger diameter than the bonding portions 2-3-1 in a region that overlaps the memory region 210 in plan view. Alternatively, a plurality of column signal processing circuits 50 may share one bonding portion 2-3-2. The number of pixel columns that share a bonding portion 2-3-2 and the area of the bonding portion 2-3-2 are not limited.

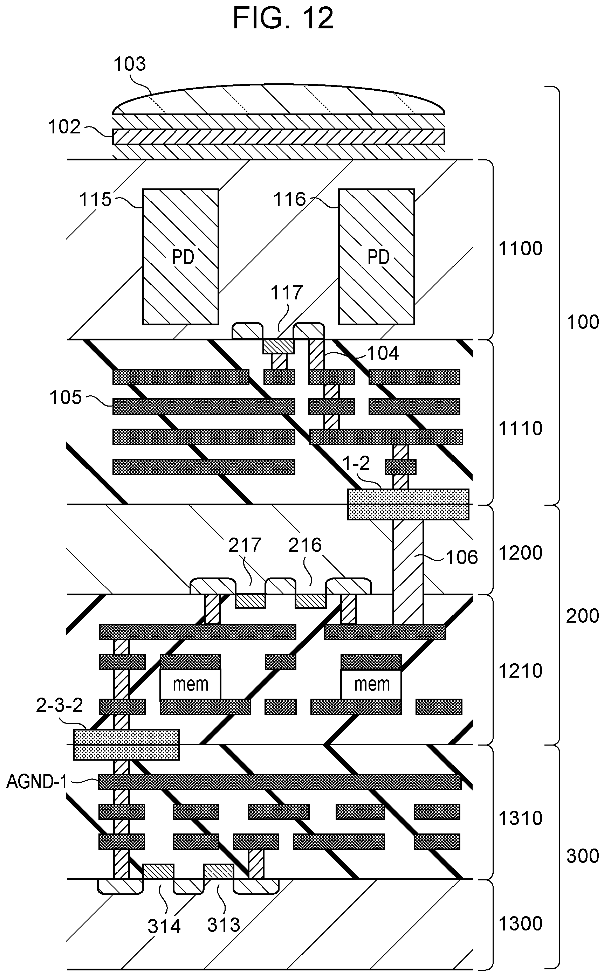

Fig. 12 is sectional view of another modification of the photoelectric conversion apparatus 10 according to the present embodiment, in which the stacking direction of the memory Si substrate 1200 and the memory chip wiring structure 1210 of the memory chip 200 is different.

In the photoelectric conversion apparatus illustrated in Fig. 12, the pixel chip wiring structure 1110 of the pixel chip 100 and the memory Si substrate 1200 of the memory chip 200 are bonded so as to face each other. Further, the memory chip wiring structure 1210 of the memory chip 200 and the signal processing chip wiring structure 1310 of the signal processing chip 300 are bonded so as to face each other.

A Cu pad provided in the pixel chip wiring structure 1110 of the pixel chip 100 and a Cu pad arranged on the top surface of the memory Si substrate 1200 are bonded together to form the bonding portion 1-2. The Cu pad on the top surface of the memory Si substrate 1200 is connected to the memory chip wiring structure 1210 through a TSV 106 penetrating the memory Si substrate 1200. Further, a Cu pad arranged on the bottom surface of the memory chip wiring structure 1210 and a Cu pad provided on the top surface of the signal processing chip wiring structure 1310 are bonded together to form the bonding portion 2-3-2.

Also in this configuration, the power supply line for supplying the reference power source AGND-1 can be common to the memory chip 200 and the signal processing chip 300, and the wiring resistance of the power supply line for supplying the reference power source AGND-1 can be reduced.

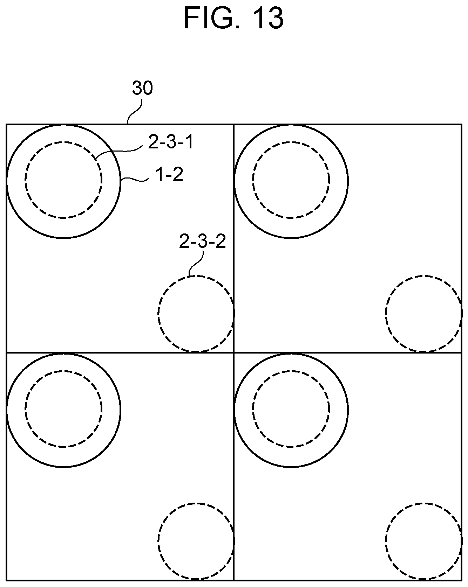

Fig. 13 illustrates the plan-view arrangement of the bonding portions 1-2, 2-3-1, and 2-3-2 in the configuration illustrated in Fig. 12. Fig. 13 is a plan view of a region having four pixels 30 arranged in two rows and two columns of the photoelectric conversion apparatus. The bonding portions 2-3-1 and 2-3-2 formed by using CCB can be smaller in diameter than the bonding portion 1-2 formed by using TSV. Thus, unlike the configuration illustrated in Fig. 9, each of the pixels 30 can be provided with the bonding portion 2-3-2. In the configuration illustrated in Fig. 13, the power supply line for supplying the reference power source AGND-1 is common to the memory chip 200 and the signal processing chip 300 to reduce the wiring resistance. Accordingly, one bonding portion 2-3-2 may be arranged for a plurality of pixels 30.

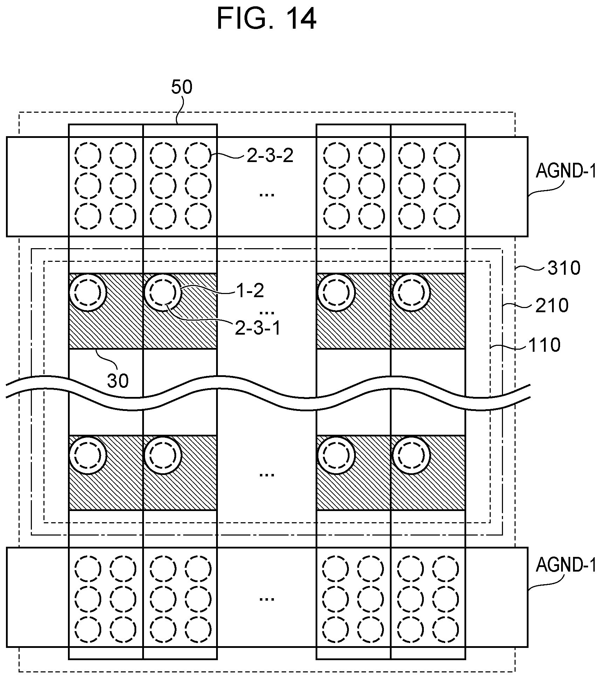

The arrangement of the bonding portions 2-3-2 formed in a region that does not overlap the region where the memory region 210 is provided will be described with reference to Fig. 14. Since the bonding portions 2-3-2 are formed by using CCB, the pitch between the bonding portions 2-3-2 can be reduced, compared to when the bonding portions 2-3-2 are formed by using TSV. As illustrated in Fig. 14, each column signal processing circuit 50 may be provided with a plurality of bonding portions 2-3-2.

Alternatively, as illustrated in Fig. 11, the area of each of the bonding portions 2-3-2 may be increased, and a plurality of column signal processing circuits 50 share one bonding portion 2-3-2.

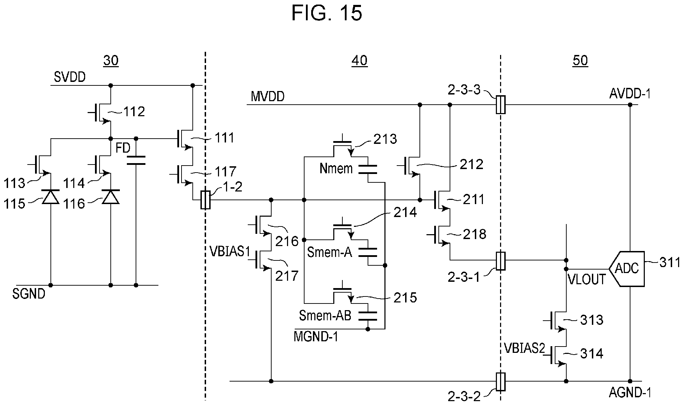

Fig. 15 illustrates an example configuration in which the power supply line for supplying the reference power source AVDD-1 and the power supply line for supplying the reference power source MVDD are common to the memory chip 200 and the signal processing chip 300 in addition to the configuration in which the power supply line for supplying the reference power source AGND-1 is common to the memory chip 200 and the signal processing chip 300. The power supply line for supplying the reference power source AVDD-1 and the power supply line for supplying the reference power source MVDD are connected to each other via a bonding portion 2-3-3. The third line for supplying power to the signal holding memory and the fifth line for supplying power to the second readout circuit can be considered to be connected to each other between the second chip and the third chip.

This configuration can also reduce the wiring resistance of the line for supplying the reference power source AVDD-1, and can reduce the constraint of the dynamic range of the signal voltage due to the voltage drop and the noise propagating to the signal line due to the power supply fluctuations, like the reference power source AGND-1. This configuration can reduce the number of pads arranged in the memory chip 200 to supply the reference power source, and is thus advantageous in reducing the chip size.

Further, the memory chip 200 may be provided with pads for the reference power source AGND-1 and the reference power source AVDD-1. In this case, the flow of a current through each pad can be distributed.

### Second Embodiment

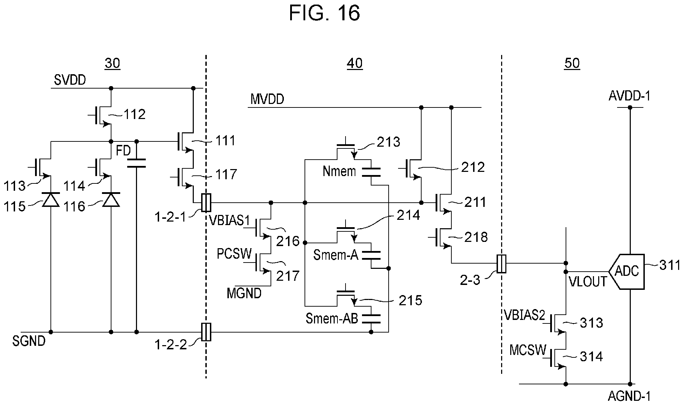

A photoelectric conversion apparatus according to a second embodiment will be described with reference to Figs. 16 to 20. A description common to the first embodiment will be omitted, and differences from the first embodiment will be mainly described.

Fig. 16 illustrates an example circuit of the photoelectric conversion apparatus according to the present embodiment. In the present embodiment, the reference power source SGND to be supplied to the pixel region 110 is supplied as a reference power source to the signal holding memory Nmem, the signal holding memory Smem-A, and the signal holding memory Smem-AB in the memory region 210.

At this time, the source of the switch transistor 217 is connected to the power supply line for supplying the reference power source MGND, and the source of the switch transistor 314 is connected to the power supply line for supplying the reference power source AGND-1. The power supply to each chip is similar to that in the first embodiment, and the current source 230 of the memory chip 200 as illustrated in Fig. 4 is supplied with the reference power source MGND. In the present embodiment, the first line for supplying power to the photoelectric conversion unit and the third line for supplying power to the signal holding memory can be connected to each other between the first chip and the second chip.

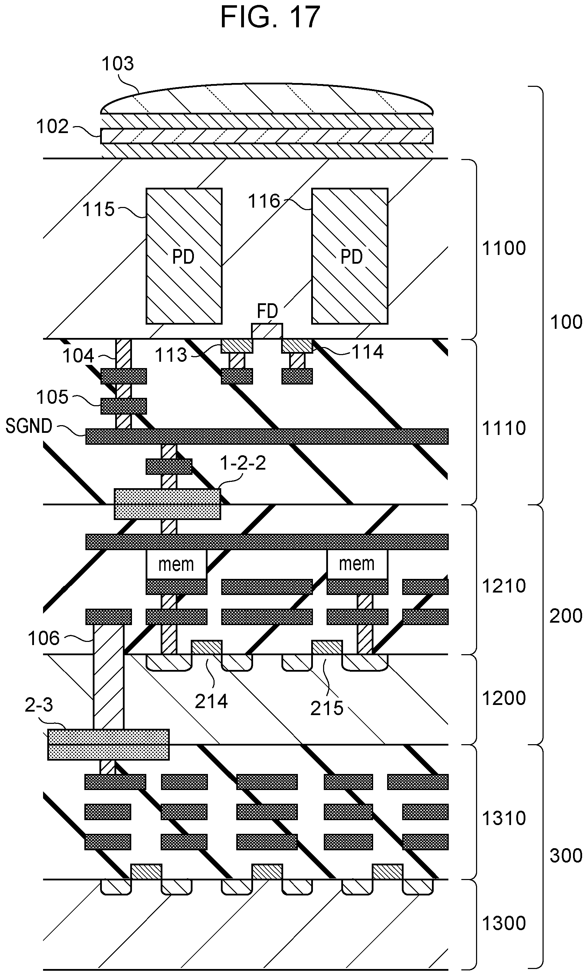

Fig. 17 illustrates the connection structure of the pixel chip 100, the memory chip 200, and the signal processing chip 300 according to the present embodiment.

In the photoelectric conversion apparatus illustrated in Fig. 17, the pixel chip wiring structure 1110 of the pixel chip 100 and the memory chip wiring structure 1210 of the memory chip 200 are bonded so as to face each other. Further, the memory Si substrate 1200 of the memory chip 200 and the signal processing chip wiring structure 1310 of the signal processing chip 300 are bonded so as to face each other.

A power supply line (SGND line) for supplying the reference power source SGND is arranged in the pixel chip 100. The SGND line is connected to the pixel Si substrate 1100 through the contact via 104, and is supplied to the PDs 115 and 116 and the FD capacitor as a reference power source. A Cu pad on the pixel chip 100 and a Cu pad on the memory chip 200 are bonded together to form a bonding portion 1-2-2. The reference power source SGND is connected to the signal holding memories arranged in the memory chip wiring structure 1210 via the bonding portion 1-2-2.

The memory chip 200 and the signal processing chip 300 are connected to a bonding portion 2-3 via a TSV 106 penetrating the memory Si substrate 1200. The bonding portion 2-3 is formed by bonding Cu pads together, and the reference power source SGND is connected to respective circuits arranged in the pixel chip 100 and the memory chip 200 by using a line common to the pixel chip 100 and the memory chip 200.

In the present embodiment, as in the first embodiment, the wiring resistance of the power supply line for supplying the reference power source SGND is reduced, thereby reducing power supply fluctuations.

In the present embodiment, furthermore, the reference power source for the FD capacitor and the reference power source for the signal holding memory Nmem, the signal holding memory Smem-A, and the signal holding memory Smem-AB are common. Accordingly, it is possible to reduce noise propagating from the reference power source when the output of the pixel amplification transistor 111 corresponding to the FD capacitor is to be written to each signal holding memory. If, as in the first embodiment, the reference power source for the FD capacitor is the reference power source SGND and the reference power source for each signal holding memory is the reference power source MGND, different noises are propagated from the reference power sources SGND and MGND supplied as separate power sources. When the output of the pixel amplification transistor 111 corresponding to the FD capacitor is to be written to the signal holding memory Nmem, the signal holding memory Smem-A, and the signal holding memory Smem-AB, the reference power source for the FD capacitor and the reference power source for the signal holding capacitors have different fluctuations. That is, signals to be written to the signal holding capacitors include power supply fluctuation components, which causes deterioration in image quality.

In addition to the noise propagated from the power source, magnetic noise propagated to wiring arranged in each chip also affects image quality. For example, in a case where the photoelectric conversion apparatus is mounted on a camera, a coil used in a stepping motor or the like of a lens generates magnetism. The voltage may fluctuate on the wiring of each chip due to the induced electromotive force. Since the pixel chip 100, the memory chip 200, and the signal processing chip 300 have different wiring structures, the propagation of noise due to magnetism differs for each reference power source connected.

Accordingly, in a case where the reference power source for the FD capacitor and the reference power source for the signal holding memories are different, the signal voltages are likely to be affected by noise. In the present embodiment, however, the power supply line for the FD capacitor and the power supply line for the signal holding memories are connected in a close manner such as within one pixel region via a bonding portion to make the reference power source for the FD capacitor and the reference power source for the signal holding memories common (the reference power source SGND). As a result, the reference power source fluctuations for writing the signal voltages to the signal holding memories are in phase between the FD capacitor and the signal holding memories, and the influence of noise on the signal voltages can be reduced.

In the present embodiment, furthermore, a reference power source (the reference power source MGND) serving as a path of a current flowing through the current source transistor 216 is separate from a reference power source for the signal holding memories. This configuration can prevent the propagation of the fluctuations of the reference power source MGND to the signal holding memories when a signal is read out from the pixel 30, that is, when a constant current is flowing in the reference power source MGND, and reduce the fluctuations in signal voltage.

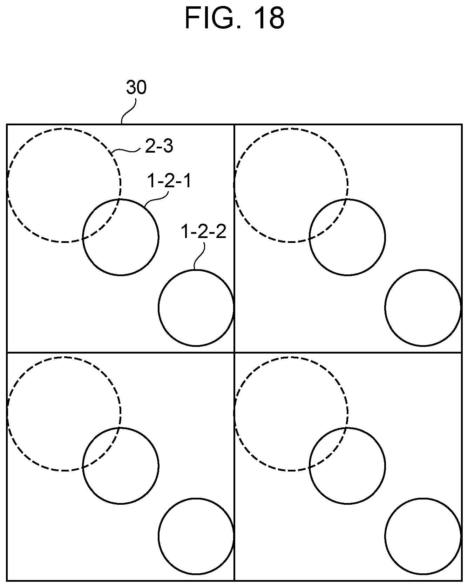

Fig. 18 illustrates four pixels 30 arranged in two rows and two columns of the photoelectric conversion apparatus illustrated in Fig. 17 as viewed from above the pixel chip 100.

The bonding portions 1-2-1 and 1-2-2 formed by using CCB can have smaller diameters than the bonding portion 2-3 corresponding to the TSV 106. Thus, each of the pixels 30 can be provided with the bonding portions 1-2-1, 1-2-2, and 2-3 in the manner as illustrated in Fig. 18.

One bonding portion 1-2-2 may be provided for a plurality of pixels 30. The reference power source fluctuations due to magnetism are affected by the wiring length. As the distance from the source of magnetism to the bonding portion 1-2-2 increases, the fluctuations in signal voltage due to magnetism is likely to increase. Accordingly, the arrangement of the bonding portion 1-2-2 for each of the pixels 30 increases the effect of reducing fluctuations in signal voltage.

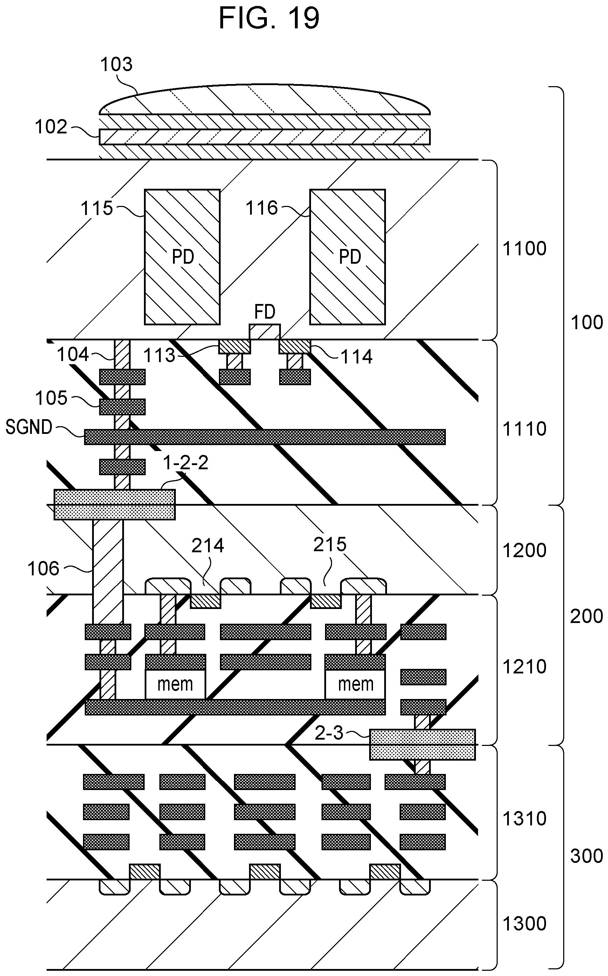

Fig. 19 is a sectional view of a photoelectric conversion apparatus according to a modification of the present embodiment, in which the power supply line for supplying the reference power source SGND is common to the pixel chip 100 and the memory chip 200. The photoelectric conversion apparatus illustrated in Fig. 19 is different from the photoelectric conversion apparatus illustrated in Fig. 17 in the stacking direction of the memory Si substrate 1200 and the memory chip wiring structure 1210 of the memory chip 200.

In the photoelectric conversion apparatus illustrated in Fig. 19, the pixel chip wiring structure 1110 of the pixel chip 100 and the memory Si substrate 1200 of the memory chip 200 are bonded so as to face each other. Further, the memory chip wiring structure 1210 of the memory chip 200 and the signal processing chip wiring structure 1310 of the signal processing chip 300 are bonded so as to face each other.

The chips 100, 200, and 300 are connected to one another through bonded Cu pads. The power supply line for supplying the reference power source SGND is connected to the memory chip wiring structure 1210 through a TSV 106 penetrating the memory Si substrate 1200. As in Fig. 17, the power supply line for supplying the reference power source SGND is common to the pixel chip 100 and the memory chip 200. This configuration can reduce fluctuations in signal voltage for writing signals to the signal holding memories.

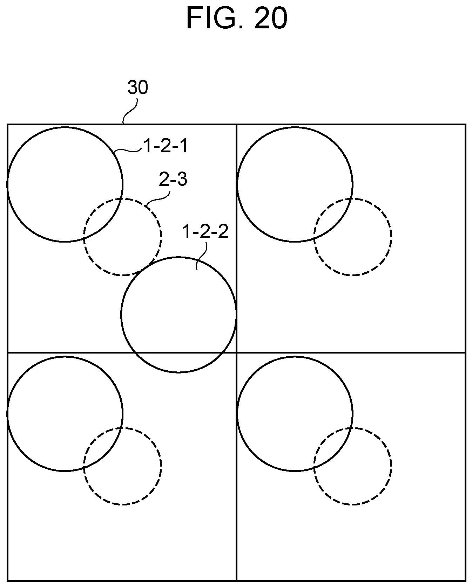

Fig. 20 illustrates four pixels 30 arranged in two rows and two columns of the photoelectric conversion apparatus illustrated in Fig. 19 as viewed from above the pixel chip 100.

The bonding portions 1-2-1 and 1-2-2 are formed by the TSV 106 penetrating the memory chip 200, and may have larger areas than the bonding portion 2-3 formed by using CCB. Thus, as illustrated in Fig. 20, for example, one bonding portion 1-2-2 may be arranged for a plurality of pixels 30.

As described above, the noise caused by power supply and the noise caused due to magnetism are superimposed on the reference power source SGND, but may be propagated through the parasitic capacitance. Accordingly, the parasitic capacitance between the power supply line and the signal output (line) needs to be reduced as much as possible. Desirably, the bonding portion 1-2-1 of each pixel 30 is located away from the bonding portion 1-2-2. Thus, the bonding portion 1-2-2 may be arranged at the center with respect to the bonding portions 1-2-1 of the four pixels 30 arranged in two rows and two columns.

### Third Embodiment

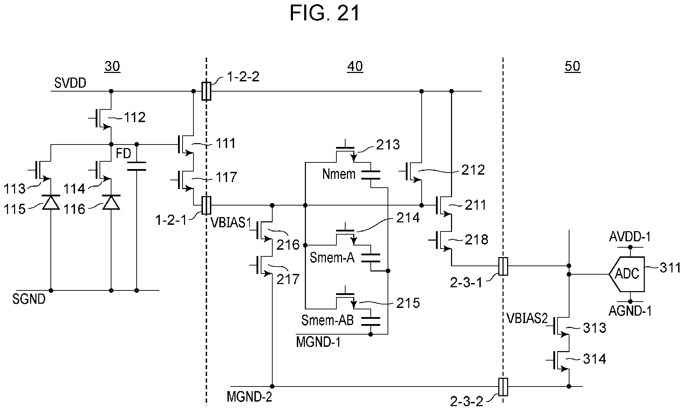

A photoelectric conversion apparatus according to a third embodiment will be described with reference to Figs. 21 to 26. A description common to the first and second embodiments will be omitted, and differences from the first embodiment will be mainly described.

Fig. 21 illustrates an example circuit of the photoelectric conversion apparatus according to the present embodiment. In the present embodiment, the reference power source SVDD is supplied to the memory chip 200 via the bonding portion 1-2-2 and is used as a power supply voltage of the pixel memory 40. Further, the reference power source AGND-1 for the ADC 311 is separate from the reference power source to be supplied to the source of the switch transistor 314. Specifically, a reference power source MGND-2 supplied to the memory chip 200 is supplied to the source of the switch transistor 314 via the bonding portion 2-3-2.

The second line for supplying power to the first readout circuit and the fourth line for supplying power to the output circuit can be considered to be connected to each other between the first chip and the second chip.

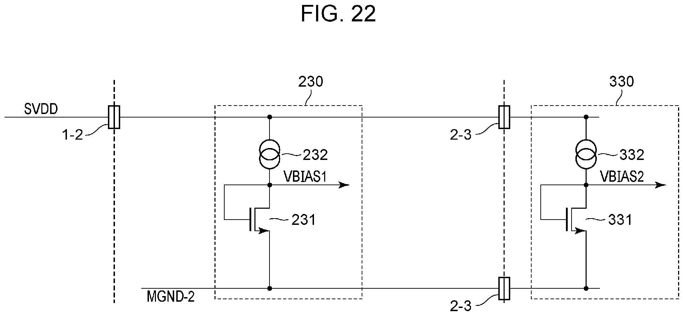

Fig. 22 illustrates the configuration of the current sources 230 and 330 according to the present embodiment.

The source of the bias generation transistor 231 of the current source 230 is connected to the reference power source MGND-2 supplied from the memory chip 200, and the drain of the bias generation transistor 231 is connected to the reference current source 232. The source of the bias generation transistor 331 of the current source 330 is connected to the reference power source MGND-2 supplied from the memory chip 200, and the drain of the bias generation transistor 331 is connected to the reference current source 332. The reference current sources 232 and 332 are connected to the reference power source SVDD supplied from the pixel chip 100.

In this case, the reference power source SVDD is supplied to the memory chip 200 and the signal processing chip 300 via the bonding portions 1-2 and 2-3. The reference power source MGND-2 is supplied from the memory chip 200 to the signal processing chip 300 via the bonding portions 2-3 and 2-3-2.

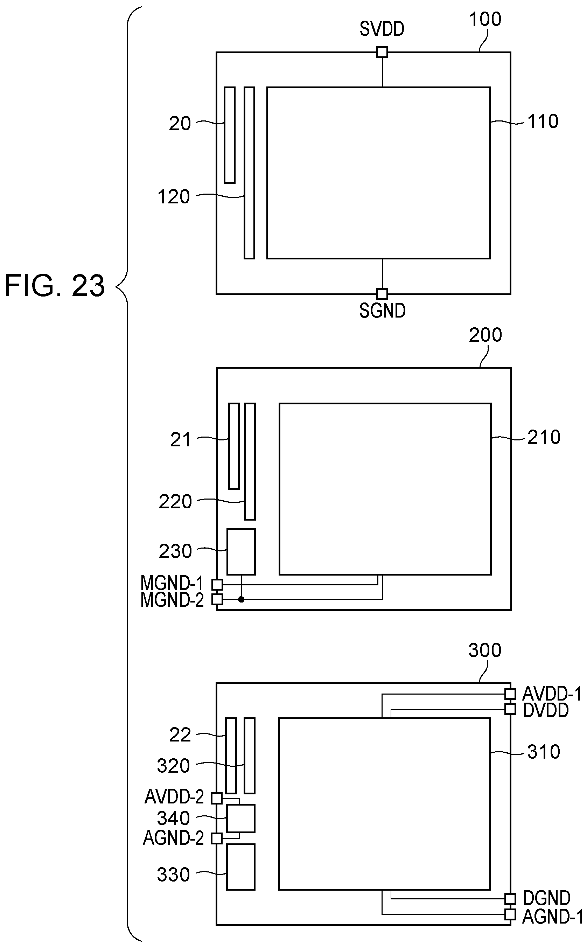

Fig. 23 illustrates an example of the power supply to the chips 100, 200, and 300 of the photoelectric conversion apparatus according to the present embodiment.

The pixel chip 100 is provided with a pad for the reference power source SVDD and a pad for the reference power source SGND.

The memory chip 200 is provided with a pad for the reference power source MGND-1 and a pad for the reference power source MGND-2.

The signal processing chip 300 is provided with a pad for the reference power source AVDD-1, a pad for the reference power source AVDD-2, a pad for the reference power source AGND-1, a pad for the reference power source AGND-2, a pad for the reference power source DVDD, and a pad for the reference power source DGND.

Unlike the wiring structure illustrated in Fig. 6 according to the first embodiment, the present embodiment does not require the power supply lines for the reference power source MVDD and the reference power source AVDD-1 to the current source 230 and the current source 330. Thus, the wiring of the power supply lines is simplified, and the circuit integration efficiency of each chip is improved.

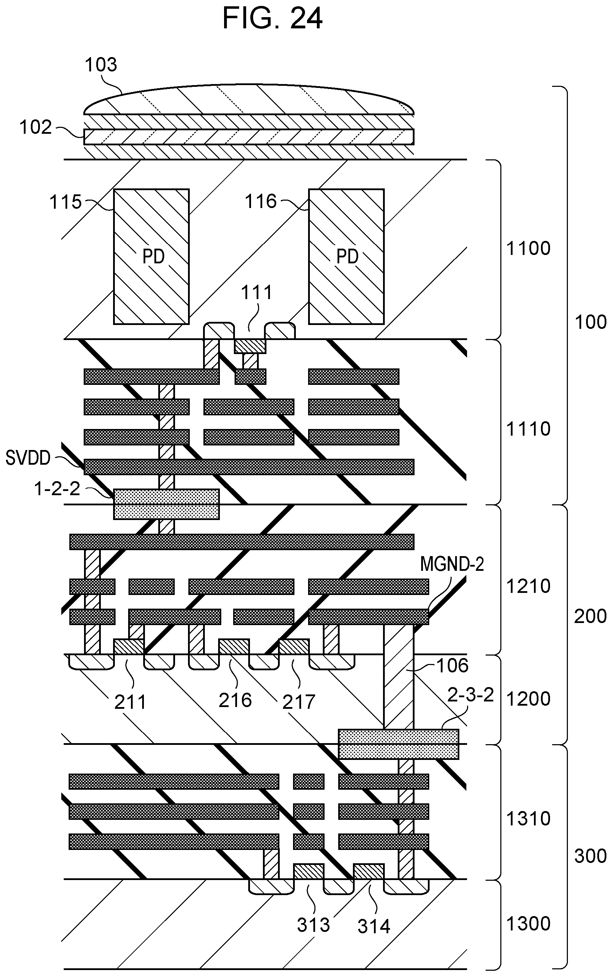

Fig. 24 is a sectional view of the photoelectric conversion apparatus according to the present embodiment.

In the photoelectric conversion apparatus illustrated in Fig. 24, the pixel chip wiring structure 1110 of the pixel chip 100 and the memory chip wiring structure 1210 of the memory chip 200 are bonded so as to face each other. Further, the memory Si substrate 1200 of the memory chip 200 and the signal processing chip wiring structure 1310 of the signal processing chip 300 are bonded so as to face each other.

A Cu pad arranged on the bottom surface of the pixel chip wiring structure 1110 and a Cu pad arranged on the top surface of the memory chip wiring structure 1210 are bonded together to form the bonding portion 1-2-2. The reference power source SVDD is supplied from the pixel chip 100 to the memory chip 200 via the bonding portion 1-2-2. The reference power source MGND-2 is supplied from the memory chip 200 to the signal processing chip 300 through a TSV 106 penetrating the memory Si substrate 1200, a Cu pad arranged on the memory Si substrate 1200, and a Cu pad arranged on the signal processing chip wiring structure 1310. Like the bonding portion 1-2-2, the bonding portions 1-2 and 2-3 for supplying power to the current sources 230 and 330 illustrated in Fig. 22 are also constructed by using CCB or TSV.

As in the first embodiment, the configuration described above can reduce the power supply wiring resistance for the path of a current flowing through the current source transistors 216 and 313 for reading out signal voltages, and reduce the fluctuations in reference power source voltage.

The configuration according to the present embodiment can also reduce fluctuations in voltage at the drain of the pixel amplification transistor 111 and the drain of the memory amplification transistor 211. In the present embodiment, the reference power source MVDD in the first embodiment is shared with the reference power source SVDD, which can reduce the number of reference power sources by one, leading to simplification of an imaging system including the photoelectric conversion apparatus.

In addition, since the reference power source AGND-1 for the ADC 311 is separate from the reference power source MGND-2, the ADC 311 is not affected by the fluctuations in the voltage of the reference power source MGND-2 in the readout operation. The dynamic range of the operation of the ADC 311 can be ensured. The gate voltages VBIAS1 and VBIAS2 fluctuate in conjunction with the fluctuations in the reference power source MGND-2. However, the current sources 230 and 330 and the current source transistors 216 and 313 share the reference power source MGND-2. Therefore, the gate-source voltages of the current source transistors 216 and 313 and the gate-source voltages of the bias generation transistors 231 and 331 are always tracked. As a result, the fluctuations in current in the readout operation can be reduced with enhancement of the stability of the operation.

In the circuit illustrated in Fig. 21, the reference power source SVDD is connected to the drain of the pixel reset transistor 112 and the drain of the memory reset transistor 212. Alternatively, the drain of the pixel reset transistor 112 and the drain of the memory reset transistor 212 may be connected to different reference power sources. The reference power source MGND-2 may be supplied from the signal processing chip 300.

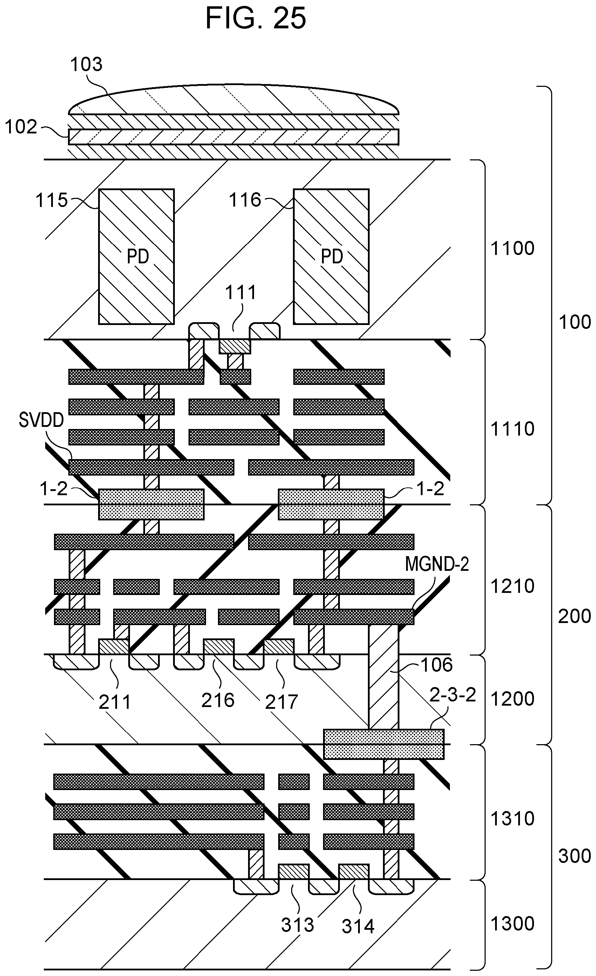

As illustrated in Fig. 25, the pixel chip wiring structure 1110 may be provided with a power supply line for supplying the reference power source MGND-2. In this case, a bonding portion 1-2 is formed to supply the reference power source MGND-2 to the memory chip 200, like the reference power source SVDD. The bonding portion 1-2 is formed by bonding together a Cu pad provided on the bottom surface of the pixel chip wiring structure 1110 and a Cu pad arranged on the top surface of the memory chip wiring structure 1210.

The reference power source MGND-2 is not supplied to the circuits on the pixel chip 100. A portion of the region of the pixel chip wiring structure 1110 is used as a wiring region of the reference power source MGND-2, which can further reduce the wiring resistance of the reference power source MGND-2.

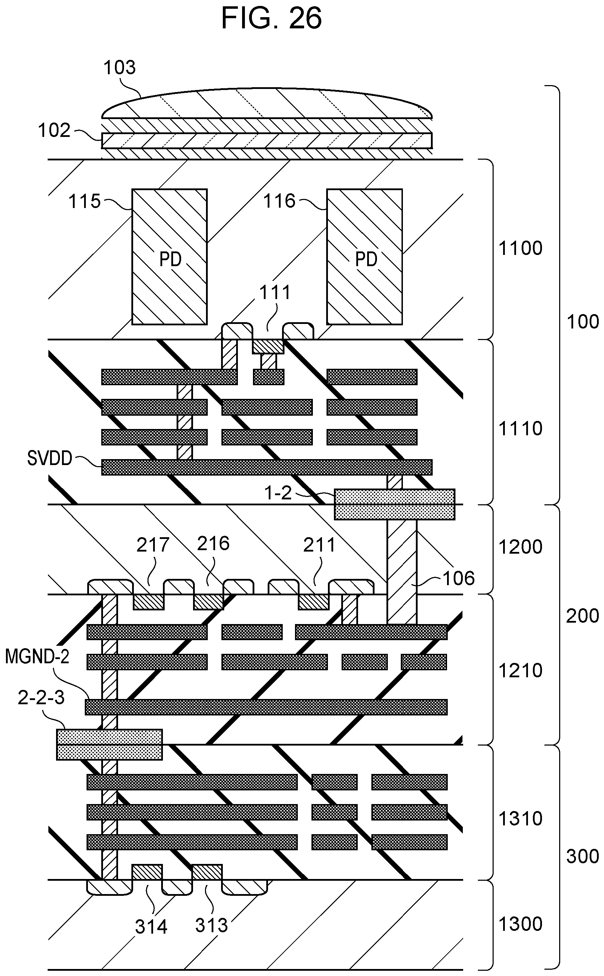

Fig. 26 is sectional view of a modification of the photoelectric conversion apparatus according to the present embodiment, in which the stacking direction of the memory Si substrate 1200 and the memory chip wiring structure 1210 of the memory chip 200 is different.

In the photoelectric conversion apparatus illustrated in Fig. 26, the pixel chip wiring structure 1110 of the pixel chip 100 and the memory Si substrate 1200 of the memory chip 200 are bonded so as to face each other. Further, the memory chip wiring structure 1210 of the memory chip 200 and the signal processing chip wiring structure 1310 of the signal processing chip 300 are bonded so as to face each other. A Cu pad arranged on the top surface of the signal processing chip wiring structure 1310 and a Cu pad arranged on the bottom surface of the memory chip wiring structure 1210 are bonded together to form the bonding portion 2-3-2. The reference power source MGND-2 provided in the wiring of the memory chip wiring structure 1210 is supplied to the signal processing chip 300 via the bonding portion 2-3-2.

Further, a TSV 106 arranged so as to penetrate the memory Si substrate 1200 is connected to a Cu pad arranged on the top surface of the memory Si substrate 1200. The Cu pad arranged on the top surface of the memory Si substrate 1200 is further connected to a Cu pad arranged on the bottom surface of the pixel chip wiring structure 1110, and the reference power source SVDD is supplied from the pixel chip 100 to the memory chip 200. The reference power source MGND-2 is supplied to both the memory chip 200 and the signal processing chip 300 through a common line. This configuration can reduce the wiring resistance of the line for the reference power source SVDD and the wiring resistance of the line for the reference power source MGND-2, which serve as a current path at the time of readout of signal voltages, and reduce the fluctuations in the voltage of each reference power source.

### Fourth Embodiment

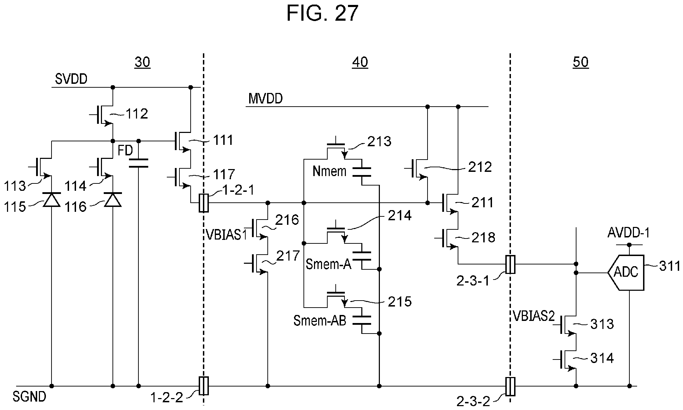

A photoelectric conversion apparatus according to a fourth embodiment will be described with reference to Figs. 27 to 32. A description common to the first embodiment will be omitted, and differences from the first embodiment will be mainly described.

Fig. 27 illustrates an example circuit of the photoelectric conversion apparatus according to the present embodiment. In the present embodiment, the reference power source SGND supplied to the pixel chip 100 is connected to the memory chip 200 and the signal processing chip 300 via the bonding portions 1-2-2 and 2-3-2. In other words, the reference power source SGND is supplied to all the layers of the pixel chip 100, the memory chip 200, and the signal processing chip 300 through a common power supply line. The first line for supplying power to the photoelectric conversion unit and the third line for supplying power to the signal holding memory can be considered to be connected to each other between the first chip and the second chip, and the third line and the fifth line for supplying power to the second readout circuit can be considered to be connected to each other between the second chip and the third chip.

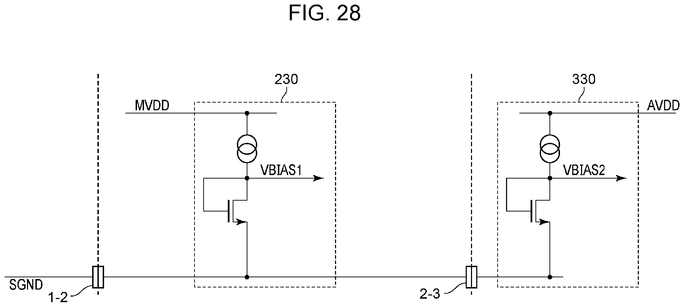

Fig. 28 illustrates the configuration of the current sources 230 and 330. The reference power source SGND supplied from the pixel chip 100 is supplied to the current source 230 via the bonding portion 1-2. The reference power source SGND is also supplied to the current source 330 via the bonding portion 2-3.

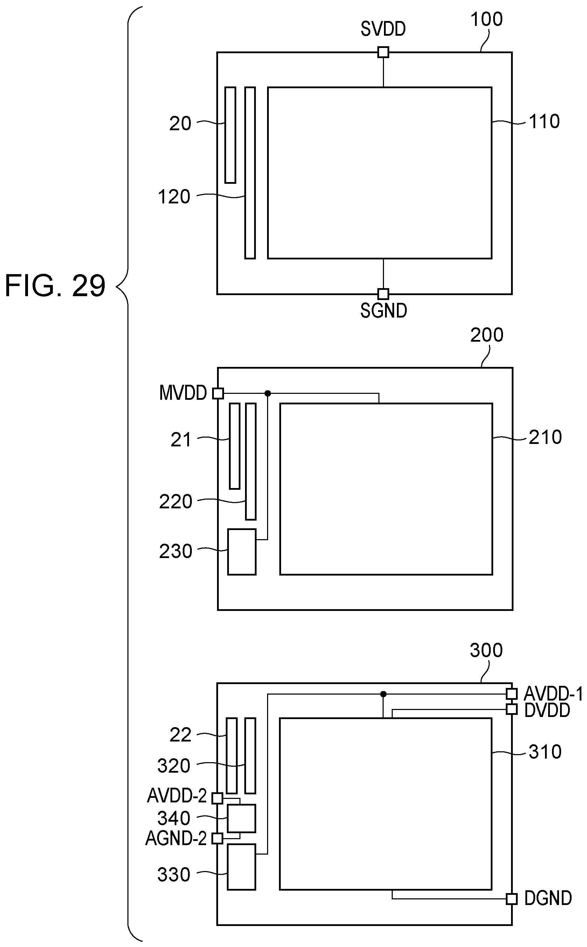

Fig. 29 illustrates an example of the power supply to the chips 100, 200, and 300 of the photoelectric conversion apparatus according to the present embodiment.

The pixel chip 100 is provided with a pad for the reference power source SVDD and a pad for the reference power source SGND.

The memory chip 200 is provided with a pad for the reference power source MVDD.

The signal processing chip 300 is provided with a pad for the reference power source AVDD-1, a pad for the reference power source AVDD-2, a pad for the reference power source AGND-2, a pad for the reference power source DVDD, and a pad for the reference power source DGND.

In the present embodiment, in contrast to the power supply to each chip according to the first embodiment illustrated in Fig. 6, the pad for supplying the reference power source MGND to the memory chip 200 and the pad for supplying the reference power source AGND-1 to the signal processing chip 300 can be eliminated. In other words, the power supply lines of the memory chip 200 and the signal processing chip 300 can be simplified. The pad for supplying the reference power source SGND may be provided in the memory chip 200 or the signal processing chip 300 instead of the pixel chip 100.

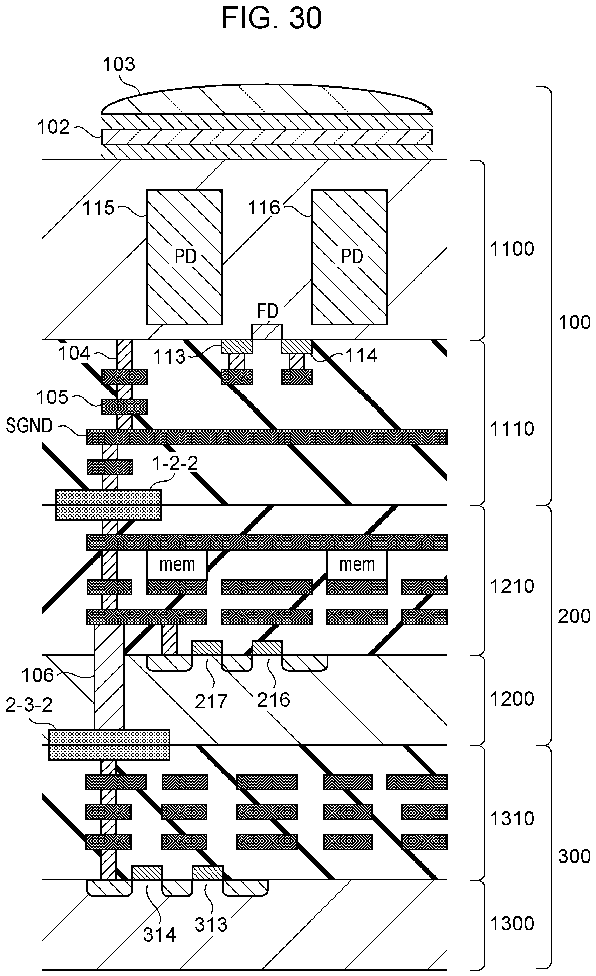

Fig. 30 is a sectional view of the photoelectric conversion apparatus according to the present embodiment.

In the photoelectric conversion apparatus illustrated in Fig. 30, the pixel chip wiring structure 1110 of the pixel chip 100 and the memory chip wiring structure 1210 of the memory chip 200 are bonded so as to face each other. Further, the memory Si substrate 1200 of the memory chip 200 and the signal processing chip wiring structure 1310 of the signal processing chip 300 are bonded so as to face each other.

The line for the reference power source SGND provided in the pixel chip wiring structure 1110 is connected to a Cu pad arranged on the bottom surface of the pixel chip wiring structure 1110 through a contact via 104. This Cu pad is bonded to a Cu pad arranged on the top surface of the memory chip wiring structure 1210 to form the bonding portion 1-2-2. A TSV 106 penetrating the memory Si substrate 1200 is connected to a Cu pad arranged on the bottom surface of the memory Si substrate 1200. The Cu pad arranged on the bottom surface of the memory Si substrate 1200 is further connected to a Cu pad arranged on the top surface of the signal processing chip wiring structure 1310, and the reference power source SGND is supplied from the memory chip wiring structure 1210 to the signal processing chip 300. The reference power source SGND is common to the pixel chip wiring structure 1110, the memory chip wiring structure 1210, and the signal processing chip wiring structure 1310, and the wiring resistance of the reference power source SGND can be reduced.

The reduction in the resistance of the power supply line for the reference power source SGND can reduce the fluctuations in the voltage of the reference power source SGND. In addition, since the reference power source SGND is shared as the reference power source connected to the FD capacitor and the reference power source connected to the signal holding memories, the fluctuations in signal voltage due to noise superimposed on the reference power source as described in the second embodiment can be reduced.

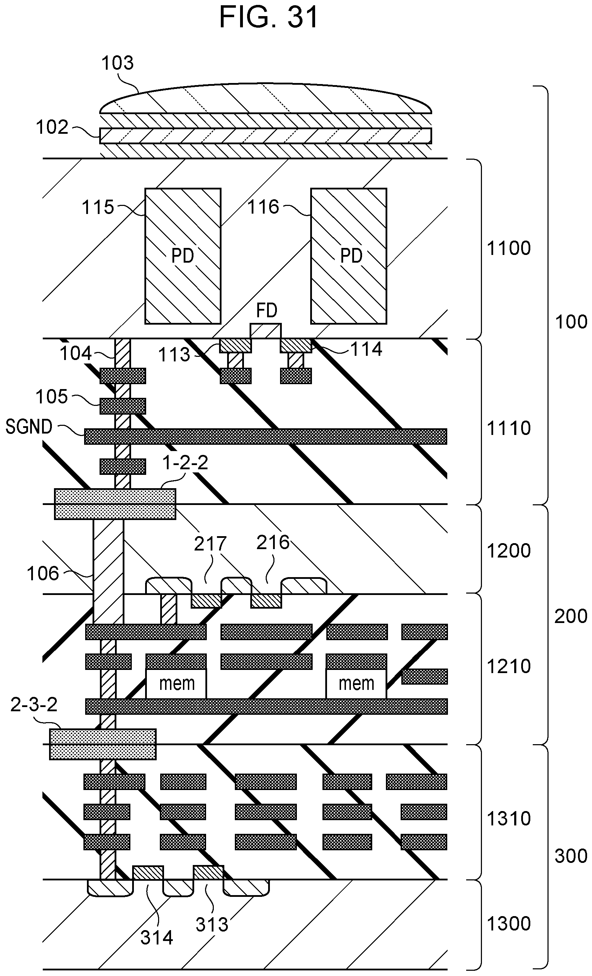

Fig. 31 is sectional view of a modification of the photoelectric conversion apparatus according to the present embodiment, in which the stacking direction of the memory Si substrate 1200 and the memory chip wiring structure 1210 of the memory chip 200 is different.

In the photoelectric conversion apparatus illustrated in Fig. 31, the pixel chip wiring structure 1110 of the pixel chip 100 and the memory Si substrate 1200 of the memory chip 200 are bonded so as to face each other. Further, the memory chip wiring structure 1210 of the memory chip 200 and the signal processing chip wiring structure 1310 of the signal processing chip 300 are bonded so as to face each other.

A Cu pad arranged on the top surface of the signal processing chip wiring structure 1310 and a Cu pad arranged on the bottom surface of the memory chip wiring structure 1210 are bonded together to form the bonding portion 2-3-2. Further, a TSV 106 penetrating the memory Si substrate 1200 is connected to a Cu pad arranged on the top surface of the memory Si substrate 1200. This Cu pad is bonded to a Cu pad arranged on the bottom surface of the pixel chip wiring structure 1110 to form the bonding portion 1-2-2. As a result, the reference power source SGND is common to the pixel chip wiring structure 1110, the memory chip wiring structure 1210, and the signal processing chip wiring structure 1310, and the resistance of the line for the reference power source SGND can be reduced.

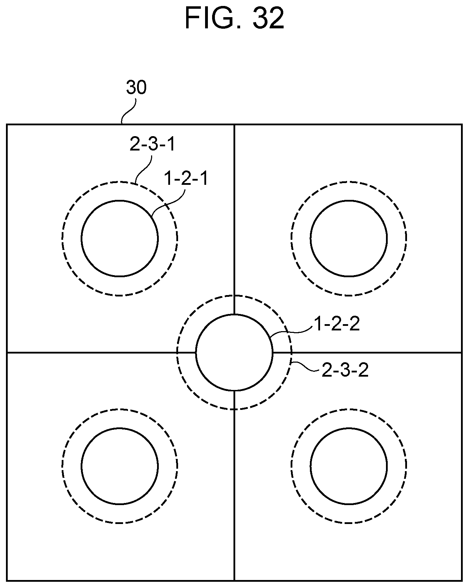

Fig. 32 illustrates four pixels 30 arranged in two rows and two columns of the photoelectric conversion apparatus illustrated in Fig. 30 as viewed from above the pixel chip 100.

Since the reference power source SGND is supplied to all the chips 100, 200, and 300 through a common power supply line, the bonding portions 1-2-2 and 2-3-2 are required. The arrangement of the bonding portions 1-2-2 and 2-3-2 in each of the pixels 30 has a large restriction in terms of area. Accordingly, for example, as illustrated in Fig. 32, the bonding portions 1-2-2 and 2-3-2 are arranged at the center of the four pixels 30 arranged in two rows and two columns. In the illustrated configuration, the bonding portions 1-2-2 and 2-3-2 are arranged so as to be surrounded by the bonding portions 1-2-1 and the bonding portions 2-3-1 serving as paths through which the signal voltages of the respective pixels 30 are output. In addition, as illustrated in Fig. 30, the power supply line for supplying the reference power source SGND has a structure that extends from the pixel chip 100 and penetrates the signal processing chip 300 through the memory chip 200. The power supply line for supplying the reference power source SGND also functions as a shield line for preventing crosstalk of signal voltages between adjacent pixels 30.

When the configuration illustrated in Fig. 31 is used, the bonding portions 2-3-1 and 2-3-2 have smaller areas than the bonding portions 1-2-1 and 1-2-2, and, as illustrated in Fig. 32, the bonding portions 1-2-2 and 2-3-2 are arranged so as to be surrounded by the bonding portions 1-2-1 and 2-3-1.

In this configuration, the reference power source SVDD, the reference power source MVDD, and the reference power source AVDD-1 may also be shared as a common reference power source using a common line. In this case, like the path for supplying the reference power source SGND, the bonding portion 1-2 is provided on the bonding surface between the pixel chip 100 and the memory chip 200 to connect the reference power source SVDD and the reference power source MVDD. In addition, like the path for supplying the reference power source SGND, the bonding portion 2-3 is provided on the bonding surface between the memory chip 200 and the signal processing chip 300 to connect the reference power source MVDD and the reference power source AVDD-1. As a result, the pads for supplying the reference power source MVDD and the reference power source AVDD-1 illustrated in Fig. 29 can be eliminated, and the wiring structure can be further simplified.

### Fifth Embodiment

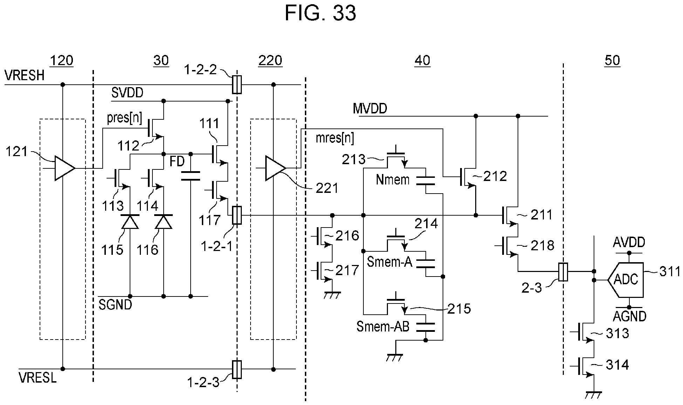

A photoelectric conversion apparatus according to a fifth embodiment will be described with reference to Figs. 33 to 37. A description common to the first embodiment will be omitted, and differences from the first embodiment will be mainly described.

Fig. 33 illustrates an example circuit of the photoelectric conversion apparatus according to the present embodiment. In the present embodiment, the vertical scanning circuit 120 is provided with a pixel drive buffer 121 to control the gates of the pixel reset transistors 112 of the pixels 30 in the n-th row by using a control line pres[n]. Further, the memory vertical scanning circuit 220 is provided with a memory drive buffer 221 to drive the gates of the memory reset transistors 212 corresponding to the pixels 30 in the n-th row by using a control line mres[n].

The pixel drive buffer 121 is supplied with a reference power source VRESH and a reference power source VRESL from the pixel chip 100, and the reference power source VRESH and the reference power source VRESL are supplied to the memory drive buffer 221 via the bonding portion 1-2-2 and a bonding portion 1-2-3.

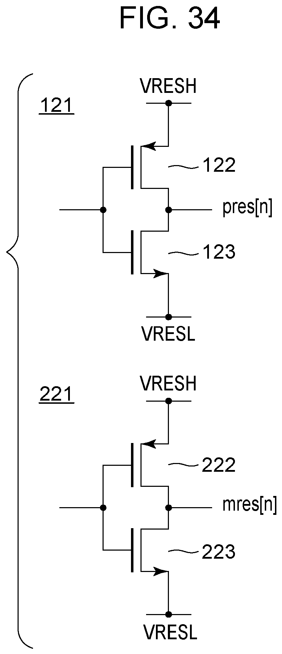

Fig. 34 illustrates an example circuit of the pixel drive buffer 121 and the memory drive buffer 221. The pixel drive buffer 121 and the memory drive buffer 221 have an inverter configuration in which P-type transistors 122 and 222 and N-type transistors 123 and 223 are vertically connected, respectively, with a source of each of the P-type transistors 122 and 222 connected to the reference power source VRESH and a source of the N-type transistors 123 and 223 connected to the reference power source VRESL. A signal input to a terminal to which gates of the P-type transistor 122 and the N-type transistor 123 are connected is output as the control line pres[n], and a signal input to a terminal to which gates of the P-type transistor 222 and the N-type transistor 223 are connected is output as the control line mres[n].

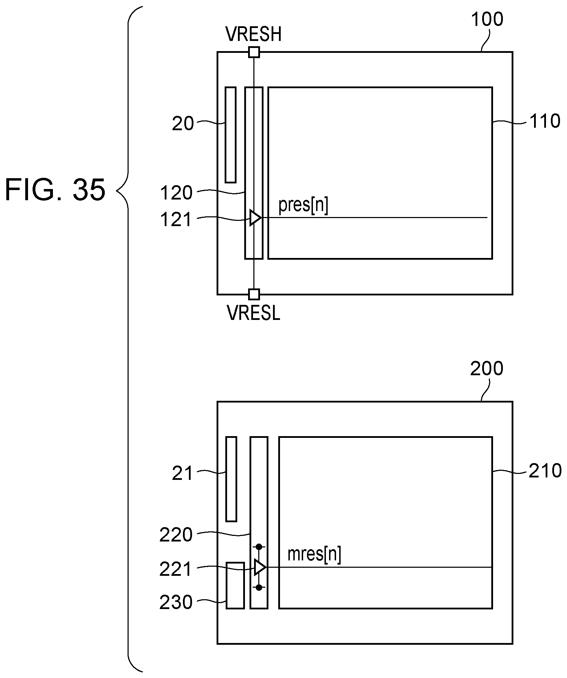

Fig. 35 illustrates an example of the power supply to the chips 100, 200, and 300 of the photoelectric conversion apparatus according to the present embodiment.

The pixel chip 100 is provided with a pad for the reference power source VRESH and a pad for the reference power source VRESL. The reference power source VRESH and the reference power source VRESL are supplied to the pixel drive buffer 121. The memory chip 200 may be provided with a pad for the reference power source VRESH and a pad for the reference power source VRESL.

It is sufficient that the signal processing chip 300 be supplied with power from any pad, which will not be described herein.

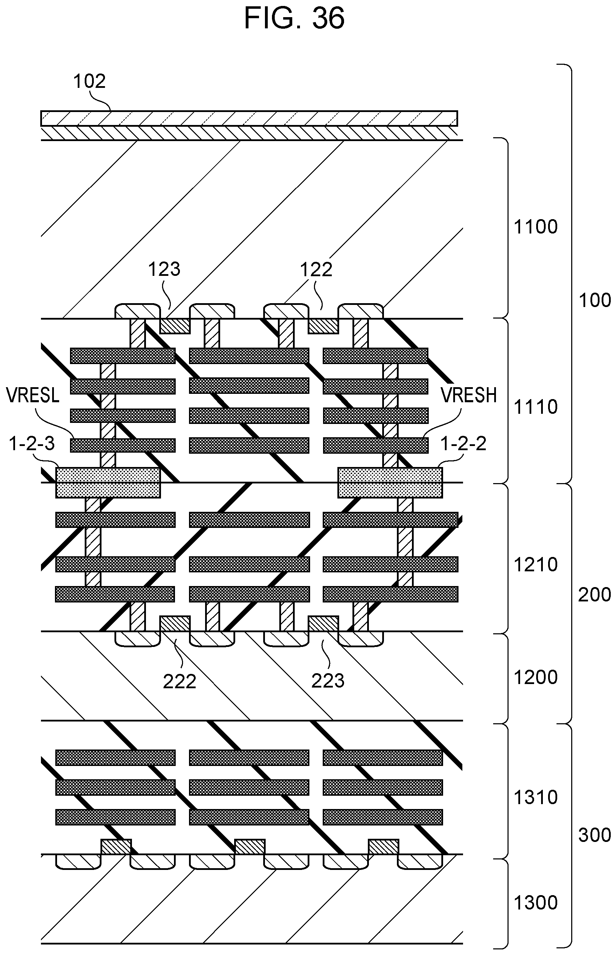

Fig. 36 is a sectional view of the photoelectric conversion apparatus according to the present embodiment. In the photoelectric conversion apparatus illustrated in Fig. 36, the pixel chip wiring structure 1110 of the pixel chip 100 and the memory chip wiring structure 1210 of the memory chip 200 are bonded so as to face each other. Further, the memory Si substrate 1200 of the memory chip 200 and the signal processing chip wiring structure 1310 of the signal processing chip 300 are bonded so as to face each other.

Cu pads arranged on the bottom surface of the pixel chip wiring structure 1110 and Cu pads arranged on the top surface of the memory chip wiring structure 1210 are bonded together to form the bonding portions 1-2-2 and 1-2-3. As a result, the power supply wiring of the pixel chip 100 and the power supply wiring of the memory chip 200 are connected to each other by bonding portions to form common power supply wiring. That is, the reference power source VRESH and the reference power source VRESL supplied from the pads provided on the pixel chip 100 or the memory chip 200 can be used as reference power sources common to the pixel chip 100 and the memory chip 200.

To drive the pixel reset transistor 112 and the memory reset transistor 212 by using the control lines pres[n] and mres[n], respectively, the voltage is changed between the reference power source VRESH and the reference power source VRESL. Accordingly, a current flows from the power supply line for the reference power source VRESH and the power supply line for the reference power source VRESL. The power supply line for the reference power source VRESH is common to the pixel chip 100 and the memory chip 200, and the power supply line for the reference power source VRESL is common to the pixel chip 100 and the memory chip 200 to reduce the wiring resistance. This configuration can reduce the fluctuations in voltage and ensure the driving stability of the pixel reset transistor 112 and the memory reset transistor 212. The current flowing during driving of the pixel reset transistor 112 and the memory reset transistor 212 increases in accordance with an increase in the number of pixels 30 and the number of pixel memories 40 in terms of the entire photoelectric conversion apparatus. Accordingly, the reduction in the resistance of the power supply line for supplying the reference power source to the driving buffer is required to increase the number of pixels of the photoelectric conversion apparatus. Thus, the configuration according to the present embodiment is advantageous in terms of increasing the number of pixels.

The photoelectric conversion apparatus illustrated in Fig. 36 has the color filter 102 on the light incident surface side thereof, but does not have the microlens 103 on the light incident surface side thereof. The reason is that the circuit described in the present embodiment is disposed outside the pixel region 110. The color filter 102 is not essential, but the color filter 102 may be arranged over the entire light incident surface of the photoelectric conversion apparatus and is thus illustrated in Fig. 36. Like the color filter 102, the microlens 103 may further be included in the configuration illustrated in Fig. 36.

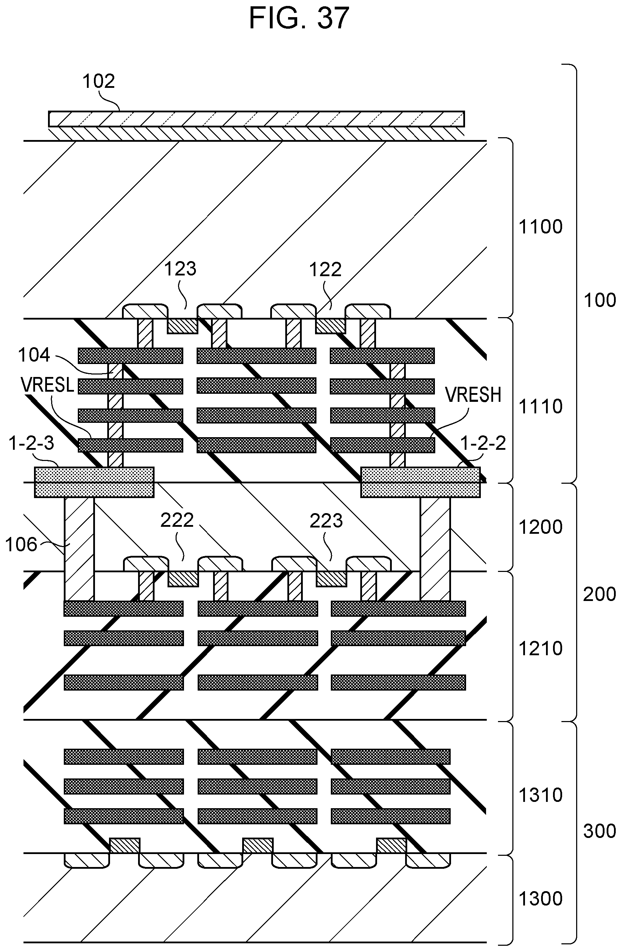

Fig. 37 is sectional view of a modification of the photoelectric conversion apparatus according to the present embodiment, in which the stacking direction of the memory Si substrate 1200 and the memory chip wiring structure 1210 of the memory chip 200 is different. In the photoelectric conversion apparatus illustrated in Fig. 37, the pixel chip wiring structure 1110 of the pixel chip 100 and the memory Si substrate 1200 of the memory chip 200 are bonded so as to face each other. Further, the memory chip wiring structure 1210 of the memory chip 200 and the signal processing chip wiring structure 1310 of the signal processing chip 300 are bonded so as to face each other.

The power supply line provided in the pixel chip wiring structure 1110 to supply the reference power source VRESH is connected to a Cu pad arranged on the bottom surface of the pixel chip wiring structure 1110 through a contact via 104. Likewise, the power supply line provided in the pixel chip wiring structure 1110 to supply the reference power source VRESL is connected to a Cu pad arranged on the bottom surface of the pixel chip wiring structure 1110 through a contact via 104. The memory chip wiring structure 1210 is connected to Cu pads arranged on the top surface of the memory Si substrate 1200 through TSVs 106 penetrating the memory Si substrate 1200. The Cu pads arranged on the bottom surface of the pixel chip wiring structure 1110 are bonded to the Cu pads arranged on the top surface of the memory Si substrate 1200 to form the bonding portions 1-2-2 and 1-2-3.

The power supply lines of the pixel chip 100 and the power supply lines of the memory chip 200 are connected to each other by the bonding portions 1-2-2 and 1-2-3 to form common power supply lines, and the reference power source VRESH and the reference power source VRESL are reference power sources common to the pixel chip 100 and the memory chip 200. This configuration can reduce the wiring resistance in the power supply line for supplying the reference power source VRESH and the power supply line for supplying the reference power source VRESL.

### Sixth Embodiment

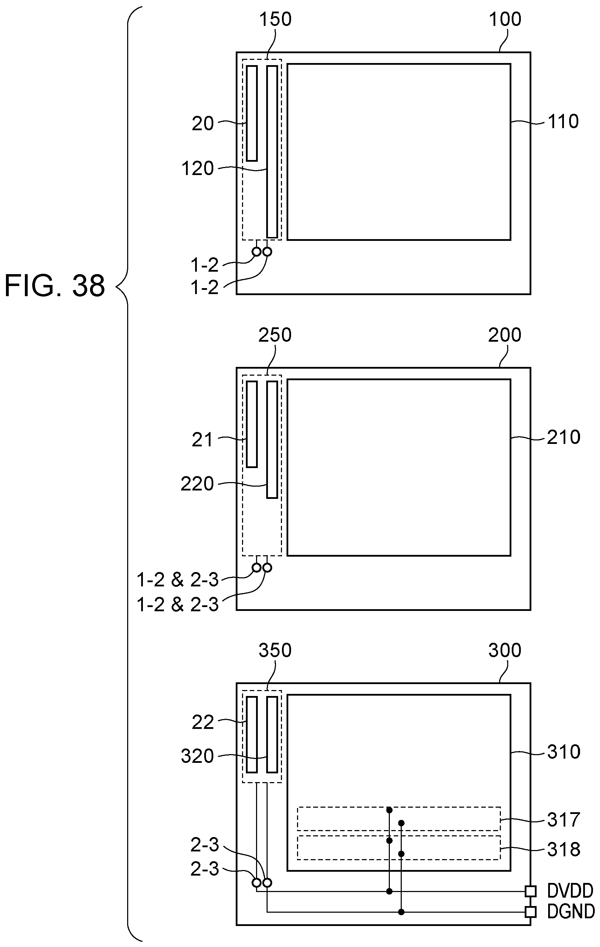

A photoelectric conversion apparatus according to a sixth embodiment will be described with reference to Figs. 38 to 42. A description common to the first embodiment will be omitted, and differences from the first embodiment will be mainly described.

The present embodiment describes the reference power source DVDD and the reference power source DGND supplied to the logic circuits arranged in the chips 100, 200, and 300 and to the counter circuit 317 and the digital processing unit 318 of each of the column signal processing circuits 50. The logic circuits are, for example, the pixel control circuit 20, the memory control circuit 21, and the signal processing control circuit 22. These circuits are constructed as typical digital circuits, and a specific circuit configuration thereof is not limited.

Fig. 38 illustrates a method of supplying power to the chips 100, 200, and 300. The signal processing chip 300 is provided with a pad for supplying the reference power source DVDD, and a pad for supplying the reference power source DGND. The reference power source DVDD and the reference power source DGND are supplied to the counter circuits 317 and the digital processing units 318 of the signal processing unit 310. The reference power source DVDD and the reference power source DGND are further supplied to a signal processing digital circuit unit 350 including the signal processing control circuit 22 and the column control circuit 320.

The memory chip 200 includes a memory digital circuit unit 250 to which the reference power source DVDD and the reference power source DGND are supplied via bonding portions 2-3. The memory digital circuit unit 250 includes the memory control circuit 21 and the memory vertical scanning circuit 220.

The pixel chip 100 includes a pixel digital circuit unit 150 to which the reference power source DVDD and the reference power source DGND are supplied via bonding portions 1-2. The pixel digital circuit unit 150 includes the pixel control circuit 20 and the vertical scanning circuit 120.

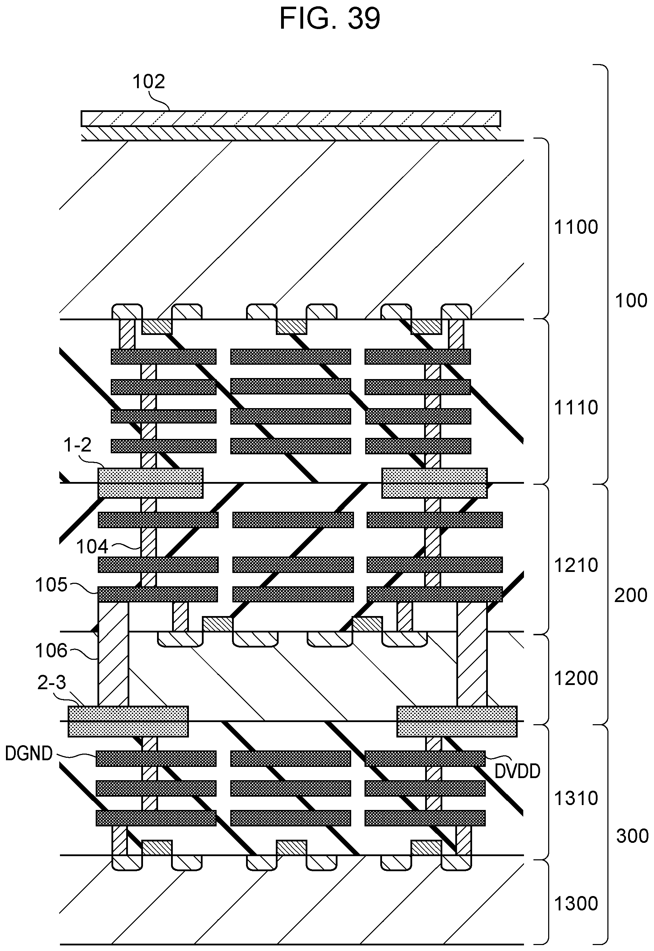

Fig. 39 is a sectional view of the photoelectric conversion apparatus according to the present embodiment. In the photoelectric conversion apparatus illustrated in Fig. 39, the pixel chip wiring structure 1110 of the pixel chip 100 and the memory chip wiring structure 1210 of the memory chip 200 are bonded so as to face each other. Further, the memory Si substrate 1200 of the memory chip 200 and the signal processing chip wiring structure 1310 of the signal processing chip 300 are bonded so as to face each other.

The reference power source DVDD and the reference power source DGND are supplied to the signal processing chip 300 via pads provided in the signal processing chip wiring structure 1310. Each of the Cu pads provided in the signal processing chip wiring structure 1310 is bonded to a corresponding Cu pad arranged on the bottom surface of the memory Si substrate 1200 to form the bonding portion 2-3. The Cu pads arranged on the bottom surface of the memory Si substrate 1200 are connected to the memory chip wiring structure 1210 through TSVs 106 penetrating the memory Si substrate 1200, and the lines of the memory chip 200 are connected to Cu pads arranged on the top surface of the memory chip wiring structure 1210 through contact vias 104. The Cu pads are bonded to Cu pads arranged in the pixel chip wiring structure 1110 to form the bonding portions 1-2.

The bonding portions 1-2 and 2-3 formed in the manner described above allow the reference power source DVDD and the reference power source DGND to serve as reference power sources common to all of the pixel chip 100, the memory chip 200, and the signal processing chip 300. Thus, the pads on the pixel chip 100 and the memory chip 200 can be eliminated.

In general, a digital circuit is likely to generate noise in relation to the signal voltage. Thus, if the reference power source to be supplied to a signal voltage readout circuit has a parasitic capacitance, noise may be propagated to the signal voltage. The present embodiment can eliminate power supply lines for supplying the reference power source DVDD and the reference power source DGND from the pads on the pixel chip 100 or the memory chip 200 to the circuits in the chips 100, 200, and 300, and can reduce propagation of noise from the reference power source DVDD and the reference power source DGND.

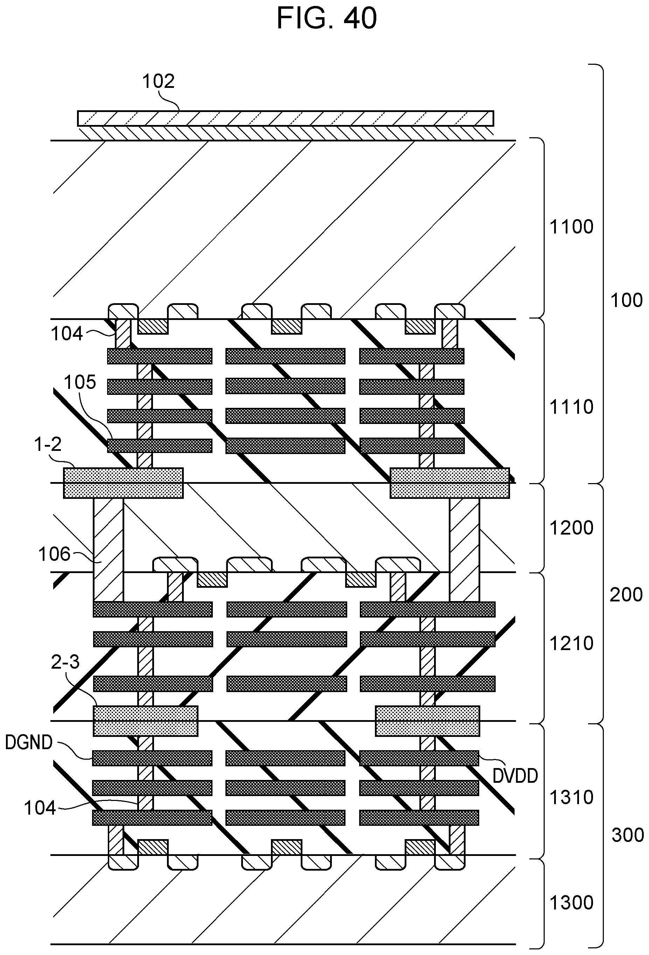

Fig. 40 is sectional view of a modification of the photoelectric conversion apparatus according to the present embodiment, in which the stacking direction of the memory Si substrate 1200 and the memory chip wiring structure 1210 of the memory chip 200 is different.

In the photoelectric conversion apparatus illustrated in Fig. 40, the pixel chip wiring structure 1110 of the pixel chip 100 and the memory Si substrate 1200 of the memory chip 200 are bonded so as to face each other. Further, the memory chip wiring structure 1210 of the memory chip 200 and the signal processing chip wiring structure 1310 of the signal processing chip 300 are bonded so as to face each other.

The reference power source DVDD and the reference power source DGND are supplied to the signal processing chip 300 via pads provided in the signal processing chip wiring structure 1310. The power supply line for the reference power source DVDD and the power supply line for the reference power source DGND in the signal processing chip wiring structure 1310 are connected to Cu pads arranged on the top surface of the signal processing chip wiring structure 1310 through contact vias 104. The Cu pads are bonded to Cu pads arranged on the bottom surface of the memory chip wiring structure 1210 to form the bonding portions 2-3.

The lines of the memory chip wiring structure 1210 are connected to Cu pads arranged on the top surface of the memory Si substrate 1200 through TSVs 106 penetrating the memory Si substrate 1200. These Cu pads are bonded to Cu pads arranged in the pixel chip wiring structure 1110 to form the bonding portions 1-2.

As a result, the reference power source DVDD and the reference power source DGND can serve as reference power sources common to the pixel chip 100, the memory chip 200, and the signal processing chip 300. In other words, as in the photoelectric conversion apparatus illustrated in Fig. 39, the effect of reducing propagation of noise from the reference power source DVDD and the reference power source DGND can be achieved.

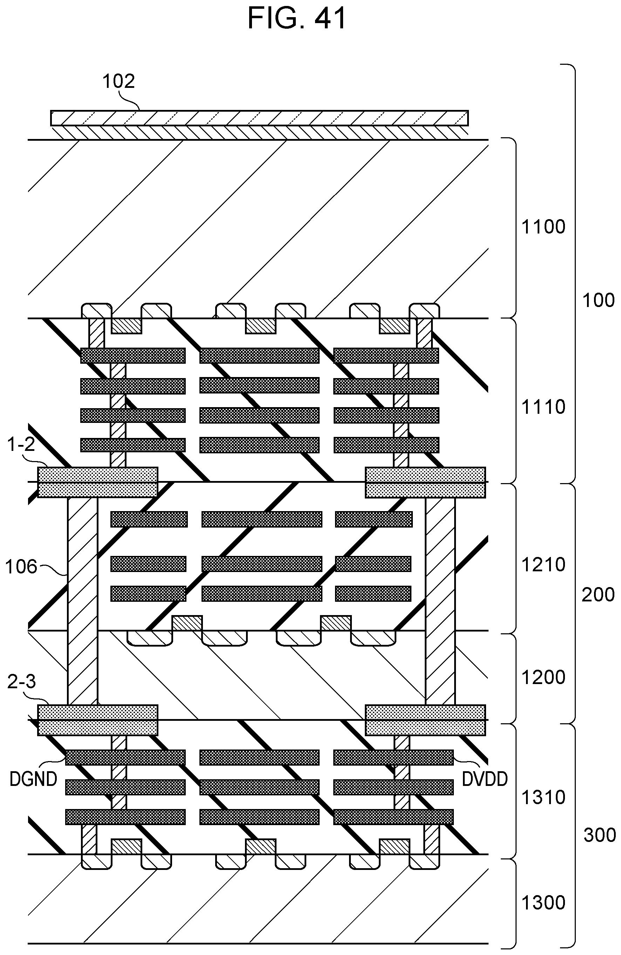

Next, a photoelectric conversion apparatus in which the memory chip 200 is not provided with power supply lines for supplying the reference power source DVDD and the reference power source DGND will be described with reference to Fig. 41. For example, the memory digital circuit unit 250 is integrated in the pixel digital circuit unit 150 or the signal processing digital circuit unit 350, and none of the reference power source DVDD and the reference power source DGND is arranged in the memory chip 200.

The photoelectric conversion apparatus illustrated in Fig. 41 is different from the photoelectric conversion apparatus illustrated in Fig. 39 in that the Cu pads of the bonding portions 1-2 and the Cu pads of the bonding portions 2-3 are connected to each other through TSVs 106 penetrating the memory Si substrate 1200 and the memory chip wiring structure 1210. In the photoelectric conversion apparatus illustrated in Fig. 41, the pixel chip wiring structure 1110 and the signal processing chip wiring structure 1310 can share the power supply line for supplying the reference power source DVDD and the power supply line for supplying the reference power source DGND.

In the photoelectric conversion apparatus illustrated in Fig. 41, the digital circuit in the memory chip 200 can be eliminated. This configuration can suppress propagation of noise from the digital circuit to the reference power sources in the memory chip 200. As a result, the effect of improving the signal voltage quality can also be expected to be achieved.

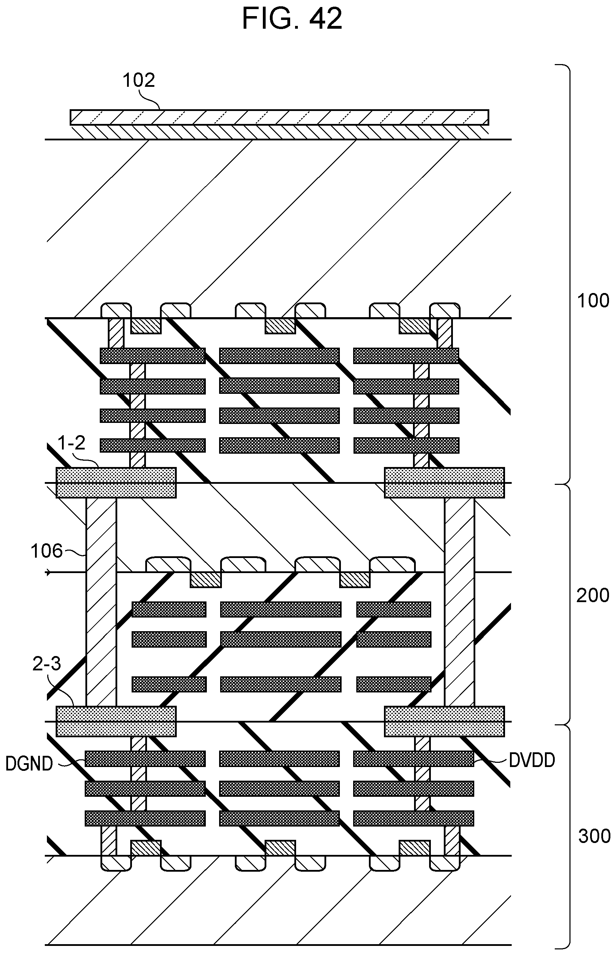

Fig. 42 is sectional view of a modification of the photoelectric conversion apparatus illustrated in Fig. 41, in which the stacking direction of the memory Si substrate 1200 and the memory chip wiring structure 1210 of the memory chip 200 is different.

In Fig. 42, as in Fig. 41, TSVs 106 penetrating the memory Si substrate 1200 and the memory chip wiring structure 1210 are arranged to connect the Cu pads of the bonding portions 1-2 and the Cu pads of the bonding portions 2-3 to each other. The power supply line for the reference power source DVDD and the power supply line for the reference power source DGND are common to the pixel chip wiring structure 1110 and the signal processing chip wiring structure 1310 via the bonding portions 1-2 and the bonding portions 2-3. In other words, like the photoelectric conversion apparatus illustrated in Fig. 41, the effects of noise reduction and improvement in signal voltage quality can be achieved. In addition, propagation of noise from the digital circuit to the reference power sources in the memory chip 200 can also be suppressed, and accordingly the effect of improving the signal voltage quality can also be expected to be achieved.

### Seventh Embodiment

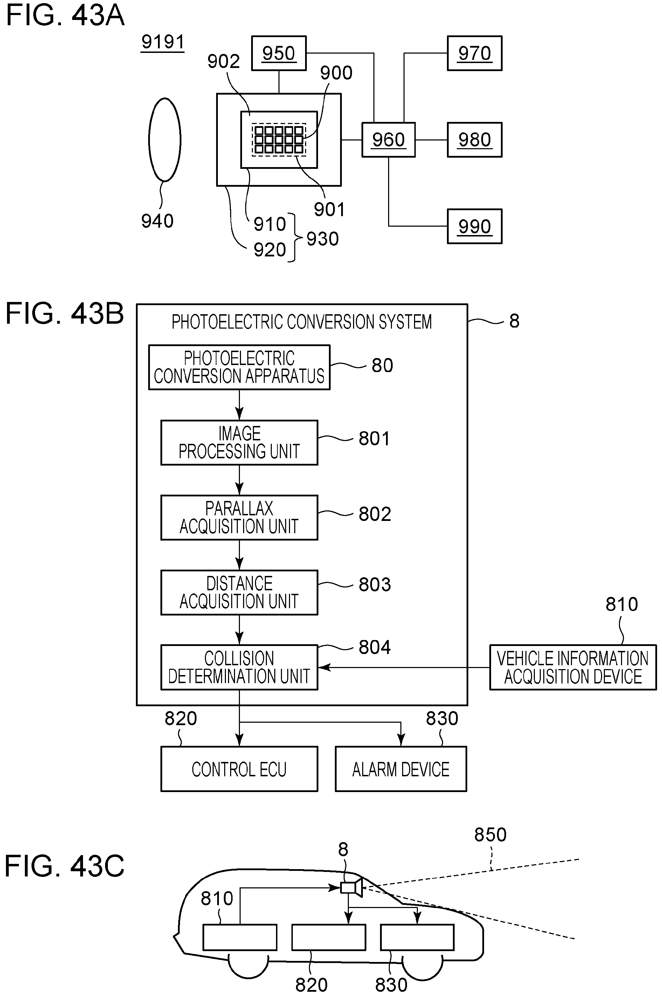

A seventh embodiment can be applied to any of the first to sixth embodiments. Fig. 43A is a schematic diagram illustrating equipment 9191 including a semiconductor apparatus 930 according to the present embodiment. The semiconductor apparatus 930 may be configured as a photoelectric conversion apparatus according to each of the embodiments described above. The equipment 9191 including the semiconductor apparatus 930 will be described in detail. The semiconductor apparatus 930 may include a semiconductor device 910 and a package 920 that houses the semiconductor device 910. The package 920 may include a base to which the semiconductor device 910 is secured and a lid such as a glass lid facing the semiconductor device 910. The package 920 may further include a bonding member such as a bonding wire or a bump that connects a terminal provided on the base and a terminal provided on the semiconductor device 910.

The equipment 9191 may include at least one of an optical device 940, a control device 950, a processing device 960, a display device 970, a storage device 980, and a mechanical device 990. The optical device 940 corresponds to the semiconductor apparatus 930. The optical device 940, examples of which include a lens, a shutter, and a mirror, includes an optical system that guides light to the semiconductor apparatus 930. The control device 950 controls the semiconductor apparatus 930. The control device 950 is, for example, a semiconductor apparatus such as an application-specific integrated circuit (ASIC).

A processor having a function of processing a signal from the semiconductor apparatus 930 to generate an image includes at least one of the processing device 960, the display device 970, the storage device 980, and the mechanical device 990.

The processing device 960 processes a signal output from the semiconductor apparatus 930. The processing device 960 is a semiconductor apparatus such as a central processing unit (CPU) or an ASIC for configuring an analog front end (AFE) or a digital front end (DFE). The display device 970 is an electroluminescent (EL) display device or a liquid crystal display device that displays information (image) obtained by the semiconductor apparatus 930. The storage device 980 is a magnetic device or a semiconductor device that stores information (image) obtained by the semiconductor apparatus 930. The storage device 980 is a volatile memory such as a static random access memory (SRAM) or a dynamic random access memory (DRAM), or a non-volatile memory such as a flash memory or a hard disk drive.

The mechanical device 990 includes a movable unit or a propulsion unit such as a motor or an engine. In the equipment 9191, a signal output from the semiconductor apparatus 930 is displayed on the display device 970 or transmitted to the outside through a communication device (not illustrated) included in the equipment 9191. Thus, the equipment 9191 may further include the storage device 980 and the processing device 960, separately from a storage circuit and an arithmetic circuit included in the semiconductor apparatus 930. The mechanical device 990 may be controlled based on a signal output from the semiconductor apparatus 930.

The equipment 9191 is also suitable for electronic equipment such as an information terminal (e.g., a smartphone or a wearable terminal) having an imaging function or a camera (e.g., an interchangeable lens camera, a compact camera, a video camera, or a surveillance camera). The mechanical device 990 in the camera can drive components of the optical device 940 for zooming, focusing, and shutter operations. Alternatively, the mechanical device 990 in the camera can move the semiconductor apparatus 930 for an anti-shake operation.

Another example of the equipment 9191 may be transport equipment such as a vehicle, a ship, or an aircraft. The mechanical device 990 in the transport equipment may be used as a moving device. The equipment 9191 serving as transport equipment is suitable for transporting the semiconductor apparatus 930 or assisting and/or automating driving (maneuvering) with an imaging function. The processing device 960 for assisting and/or automating driving (maneuvering) can perform processing for operating the mechanical device 990 serving as a moving device on the basis of information obtained by the semiconductor apparatus 930. Alternatively, the equipment 9191 may be medical equipment such as an endoscope, measurement equipment such as a distance measuring sensor, analysis equipment such as an electron microscope, office equipment such as a copier, or industrial equipment such as a robot.

According to the embodiments described above, it is possible to obtain favorable pixel characteristics. It is therefore possible to increase the value of the semiconductor apparatus. The phrase "increasing the value" corresponds to at least one of addition of a function, improvement in performance, improvement in characteristics, improvement in reliability, improvement in manufacturing yield, reduction in environmental load, reduction in cost, reduction in size, and reduction in weight.

Thus, when the semiconductor apparatus 930 according to the present embodiment is used in the equipment 9191, the value of the equipment 9191 can also be increased. For example, the semiconductor apparatus 930 mounted on transport equipment can achieve excellent performance when capturing an image of an external environment of the transport equipment or measuring the external environment. Therefore, when manufacturing and selling transport equipment, deciding to mount the semiconductor apparatus according to the present embodiment on the transport equipment is advantageous for enhancing the performance of the transport equipment. In particular, the semiconductor apparatus 930 is suitable for transport equipment that uses information obtained by the semiconductor apparatus 930 for assisted and/or automated driving of the transport equipment.

A photoelectric conversion system and a mobile object according to the present embodiment will be described with reference to Figs. 43B and 43C.

Fig. 43B illustrates an example of a photoelectric conversion system 8 for a camera on board a vehicle. The photoelectric conversion system 8 includes a photoelectric conversion apparatus 80. The photoelectric conversion apparatus 80 is the photoelectric conversion apparatus (imaging apparatus) according to any of the embodiments described above. The photoelectric conversion system 8 includes an image processing unit 801 and a parallax acquisition unit 802. The image processing unit 801 performs image processing on a plurality of pieces of image data acquired by the photoelectric conversion apparatus 80. The parallax acquisition unit 802 calculates a parallax (a phase difference between parallax images) from the plurality of pieces of image data acquired by the photoelectric conversion apparatus 80. The photoelectric conversion system 8 further includes a distance acquisition unit 803 and a collision determination unit 804. The distance acquisition unit 803 calculates a distance to an object on the basis of the calculated parallax. The collision determination unit 804 determines whether the vehicle is likely to collide with the object, on the basis of the calculated distance. The parallax acquisition unit 802 and the distance acquisition unit 803 are examples of distance information acquisition means configured to acquire distance information to an object. That is, the distance information is, for example, information related to a parallax, a defocus amount, and/or a distance to the object. The collision determination unit 804 may use any of these pieces of distance information to determine the possibility of a collision. The distance information acquisition means may be implemented by hardware designed for exclusive use, or may be implemented by a software module. Alternatively, the distance information acquisition means may be implemented by a field programmable gate array (FPGA), an ASIC, or the like, or may be implemented by a combination thereof.

The photoelectric conversion system 8 is connected to a vehicle information acquisition device 810, and can acquire vehicle information such as a vehicle speed, a yaw rate, and a steering angle. The photoelectric conversion system 8 is further connected to a control electronic control unit (ECU) 820. The control ECU 820 is a control unit that outputs a control signal for generating a braking force to the vehicle on the basis of the determination result obtained by the collision determination unit 804. The photoelectric conversion system 8 is also connected to an alarm device 830. The alarm device 830 issues an alarm to the driver of the vehicle on the basis of the determination result obtained by the collision determination unit 804. For example, when the collision determination unit 804 determines that a collision is likely to occur, the control ECU 820 performs vehicle control to avoid the collision or reduce damage by, for example, applying a brake, releasing an accelerator pedal, or suppressing an engine output. The alarm device 830 warns the user by, for example, sounding an alarm such as a sound, displaying alarm information on a screen of a car navigation system or the like, or vibrating a seat belt or a steering wheel.

In the present embodiment, the photoelectric conversion system 8 captures an image of an area around the vehicle, for example, an area ahead of or behind the vehicle.

Fig. 43C illustrates the photoelectric conversion system 8 when the photoelectric conversion system 8 captures an image of an area ahead of the vehicle (an imaging range 850). The vehicle information acquisition device 810 transmits an instruction to the photoelectric conversion system 8 or the photoelectric conversion apparatus 80. This configuration can further improve the accuracy of distance measurement.

In the example described above, the vehicle is controlled not to collide with another vehicle. However, the present embodiment can also be applied to, for example, automated driving control to follow another vehicle ahead, and/or automated driving control to keep a lane. Further, the photoelectric conversion system according to the present embodiment may be applied not only to a vehicle such as an automobile but also to a mobile object (moving device) such as a ship, an aircraft, or an industrial robot. The photoelectric conversion system according to the present embodiment may also be applied to, in addition to a mobile object, a wide variety of equipment using object recognition, such as an intelligent transportation system (ITS).

The disclosure herein includes not only what is described in this specification but also all matters that can be understood from this specification and the accompanying drawings. The disclosure herein also includes the complement of a concept described herein. That is, for example, if it is described herein that "A is larger than B", it can be inferred that the concept "A is not larger than B" is also disclosed herein, even if the description "A is not larger than B" is omitted herein. The reason is that the description "A is larger than B" is based on the assumption that the case where "A is not larger than B" is considered.

The disclosure of the embodiments described above includes the following configurations.

### Configuration 1

A photoelectric conversion apparatus includes a first chip including a first semiconductor layer and a first wiring structure. The first semiconductor layer includes a photoelectric conversion unit and a first readout circuit configured to read out a signal based on photoelectric conversion of the photoelectric conversion unit. The first wiring structure is electrically connected to the photoelectric conversion unit and the first readout circuit. The photoelectric conversion apparatus includes a second chip including a second semiconductor layer and a second wiring structure. The second semiconductor layer includes a memory configured to hold a voltage corresponding to the signal and an output circuit configured to output the voltage held in the memory. The second wiring structure is electrically connected to the memory and the output circuit. The photoelectric conversion apparatus includes a third chip including a third semiconductor layer and a third wiring structure. The third semiconductor layer includes a second readout circuit configured to read out a signal corresponding to the voltage held in the memory. The third wiring structure is electrically connected to the second readout circuit. The first chip, the second chip, and the third chip are stacked. The first wiring structure includes a first line configured to supply power to the photoelectric conversion unit and a second line configured to supply power to the first readout circuit. The second wiring structure includes a third line configured to supply power to the memory and a fourth line configured to supply power to the output circuit. The third wiring structure includes a fifth line configured to supply first power to the second readout circuit and a sixth line configured to supply second power different from the first power to the second readout circuit. At least two lines among the first line, the second line, the third line, the fourth line, the fifth line, and the sixth line are connected to each other between at least two chips among the first chip, the second chip, and the third chip.

### Configuration 2

The photoelectric conversion apparatus according to Configuration 1, in which the first line and the third line are connected to each other.

### Configuration 3

The photoelectric conversion apparatus according to Configuration 2, in which the third line and the fifth line are connected to each other.

### Configuration 4

The photoelectric conversion apparatus according to any one of Configurations 1 to 3, in which the second line and the fourth line are connected to each other.

### Configuration 5

The photoelectric conversion apparatus according to Configuration 4, in which the fourth line and the sixth line are connected to each other.

### Configuration 6

The photoelectric conversion apparatus according to any one of Configurations 1 to 5, in which the first semiconductor layer includes a pixel region having the photoelectric conversion unit, and the at least two lines are connected to a bonding portion arranged in a region that overlaps the pixel region in plan view. Configuration 7

The photoelectric conversion apparatus according to Configuration 2, in which the first semiconductor layer includes a pixel amplification transistor configured to amplify a signal output from the photoelectric conversion unit, and the second semiconductor layer includes a memory amplification transistor configured to amplify a signal output from the memory. In the photoelectric conversion apparatus according to Configuration 2, the first line is configured to supply power to the pixel amplification transistor, and the third line is configured to supply power to the memory amplification transistor.

### Configuration 8

The photoelectric conversion apparatus according to any one of Configurations 1 to 7, in which the third line is configured to supply power to both the memory and a current source configured to supply a reference current to the memory. Configuration 9

The photoelectric conversion apparatus according to any one of Configurations 1 to 8, in which the at least two lines are connected to each other between the first chip and the second chip and arranged in the third chip. Configuration 10

The photoelectric conversion apparatus according to any one of Configurations 1 to 7, in which at least one of the first line and the second line included in the first wiring structure is connected to at least one of the fifth line and the sixth line included in the third wiring structure through a through-electrode penetrating the second semiconductor layer.

### Configuration 11

A photoelectric conversion system including the photoelectric conversion apparatus according to any one of Configurations 1 to 10, and a processor configured to generate an image using a signal output from the photoelectric conversion apparatus.

### Configuration 12

A mobile object including:
the photoelectric conversion apparatus according to any one of Configurations 1 to 10; and
a control unit configured to control movement of the mobile object by using a signal output from the photoelectric conversion apparatus.

According to an embodiment of the present disclosure, in a photoelectric conversion apparatus having a plurality of substrates that are stacked, the wiring resistance of power supply lines can be reduced.

While the present invention has been described with reference to embodiments, it is to be understood that the invention is not limited to the disclosed embodiments.

## Claims

1. A photoelectric conversion apparatus comprising:
a first chip (100) including
a first semiconductor layer (1100) including a photoelectric conversion unit and a first readout circuit configured to read out a signal based on photoelectric conversion of the photoelectric conversion unit, and
a first wiring structure (1110) electrically connected to the photoelectric conversion unit and the first readout circuit;
a second chip (200) including
a second semiconductor layer (1200) including a memory configured to hold a voltage corresponding to the signal and an output circuit configured to output the voltage held in the memory, and
a second wiring structure (1210) electrically connected to the memory and the output circuit; and
a third chip (300) including
a third semiconductor layer (1300) including a second readout circuit configured to read out a signal corresponding to the voltage held in the memory, and
a third wiring structure (1310) electrically connected to the second readout circuit,
the first chip, the second chip, and the third chip being stacked, wherein
the first wiring structure includes a first line configured to supply power to the photoelectric conversion unit and a second line configured to supply power to the first readout circuit,
the second wiring structure includes a third line configured to supply power to the memory and a fourth line configured to supply power to the output circuit,
the third wiring structure includes a fifth line configured to supply first power to the second readout circuit and a sixth line configured to supply second power different from the first power to the second readout circuit, and
at least two lines among the first line, the second line, the third line, the fourth line, the fifth line, and the sixth line are connected to each other between at least two chips among the first chip, the second chip, and the third chip.

2. The photoelectric conversion apparatus according to Claim 1, wherein the first line and the third line are connected to each other.

3. The photoelectric conversion apparatus according to Claim 2, wherein the third line and the fifth line are connected to each other.

4. The photoelectric conversion apparatus according to any one of Claims 1 to 3, wherein the second line and the fourth line are connected to each other.

5. The photoelectric conversion apparatus according to Claim 4, wherein the fourth line and the sixth line are connected to each other.

6. The photoelectric conversion apparatus according to any one of Claims 1 to 5, wherein
the first semiconductor layer includes a pixel region (110) having the photoelectric conversion unit, and
the at least two lines are connected to a bonding portion arranged in a region that overlaps the pixel region in plan view.

7. The photoelectric conversion apparatus according to Claim 2, wherein
the first semiconductor layer includes a pixel amplification transistor (111) configured to amplify a signal output from the photoelectric conversion unit,
the second semiconductor layer includes a memory amplification transistor (211) configured to amplify a signal output from the memory,
the first line is configured to supply power to the pixel amplification transistor, and
the third line is configured to supply power to the memory amplification transistor.

8. The photoelectric conversion apparatus according to any one of Claims 1 to 7, wherein the third line is configured to supply power to both the memory and a current source (230) configured to supply a reference current to the memory.

9. The photoelectric conversion apparatus according to any one of Claims 1 to 8, wherein the at least two lines are connected to each other between the first chip and the second chip and arranged in the third chip.

10. The photoelectric conversion apparatus according to any one of Claims 1 to 7, wherein at least one of the first line and the second line included in the first wiring structure is connected to at least one of the fifth line and the sixth line included in the third wiring structure through a through-electrode penetrating the second semiconductor layer.

11. A photoelectric conversion system comprising:
the photoelectric conversion apparatus (10; 930; 80) according to any one of Claims 1 to 10; and
a processor (960, 970, 980, 990; 801) configured to generate an image using a signal output from the photoelectric conversion apparatus.

12. A mobile object comprising:
the photoelectric conversion apparatus (10; 80) according to any one of Claims 1 to 10; and
a control unit (820) configured to control movement of the mobile object by using a signal output from the photoelectric conversion apparatus.
